# EUROPEAN PATENT APPLICATION

(11) **EP 4 761 505 A1**
(43) Date of publication of application: **17.06.2026**
(21) Application number: 25199601.3
(22) Date of filing: 02.09.2025
(51) Int. Cl.: H10D 30/47, H10W 74/10, H10W 74/43, H10D 64/20, H10D 62/17, H10D 64/23, H10D 62/85

(54) **SEMICONDUCTOR DEVICE**

(30) Priority: 12.12.2024 KR 20240185262
(71) Applicant: Samsung Electronics Co., Ltd., Suwon-si, Gyeonggi-do 16677 (KR)
(72) Inventor: PARK, Junhyuk, Suwon-si (KR); KIM, Jongseob, Suwon-si (KR); YANG, Seong Seok, Suwon-si (KR); OH, Jaejoon, Suwon-si (KR); HWANG, In Jun, Suwon-si (KR)
(74) Representative: Marks & Clerk LLP

(57) **Abstract**

A semiconductor device includes a channel layer (132), a barrier layer (136); a gate electrode (155), a gate semiconductor layer (152) positioned between the barrier layer and the gate electrode; a first protective layer (210) positioned on the barrier layer, the first protective layer comprising a first material; a source electrode (170) on a first side of the gate electrode; a drain electrode (190) on a second side of the gate electrode; a first field dispersion layer (177a); a second protective layer (220), and a third protective layer (230) comprising a third lower protective layer (231) and comprising the first material, a third upper protective layer (233) comprising the first material, and a third interlayer protective layer (233) comprising the first material, wherein the content by atomic percentage (at%) of the first material in the third lower protective layer, the third interlayer protective layer, or the third upper protective layer is greater than the content (at%) of the first material in the first protective layer.

## Description

### BACKGROUND

### 1. Field

The present disclosure relates to a semiconductor device.

### 2. Description of the Related Art

In modern society, semiconductor devices are closely related to our daily lives. In particular, the importance of power semiconductor devices used in various fields such as transportation such as electric vehicles, railways, and electric trams, renewable energy systems such as solar power generation and wind power generation, and mobile devices is gradually increasing. The electric power semiconductor device is a semiconductor device used to handle high voltage or high current, and perform functions such as power conversion and control in large power systems or high-power electronic devices. Electric power semiconductor device has an ability to handle high power and durability, allowing them to handle large amounts of current and withstand high voltages. For example, an electric power semiconductor device may handle the voltages of hundreds to thousands of volts and the currents from tens to thousands of amperes. Electric power semiconductor devices may improve the efficiency of electrical energy usage by minimizing power loss. Additionally, electric power semiconductor devices may operate stably even in environments such as high temperatures.

These electric power semiconductor devices may be classified by material, for example, there are SiC electric power semiconductor devices and GaN power semiconductor devices. By manufacturing the electric power semiconductor devices using SiC or GaN instead of conventional silicon wafers (Si wafers), drawbacks of silicon, which has unstable characteristics at high temperatures, may be compensated. SiC electric power semiconductor devices are resistant to high temperatures and have low power loss, making them suitable for electric vehicles and renewable energy systems. GaN electric power semiconductor devices require high costs, but are efficient in terms of speed and may be suitable for high-speed charging of mobile devices.

### SUMMARY

Aspects of the disclosed embodiments provide a semiconductor device with stable electric characteristics and improved reliability.

According to an embodiment, a semiconductor device includes a channel layer, a barrier layer positioned on the channel layer and including a material having a different energy band gap from an energy band gap of the channel layer; a gate electrode positioned on the barrier layer, a gate semiconductor layer positioned between the barrier layer and the gate electrode; a first protective layer positioned on the barrier layer and covering the gate electrode, the first protective layer comprising a first material; source electrodes positioned on a first side of the gate electrode and connected to the channel layer, drain electrodes positioned on a second side of the gate electrode opposite the first side of the gate electrode and connected to the channel layer, a first field dispersion layer positioned on the first protective layer and connected to the source electrodes; a second protective layer positioned on the first protective layer and covering the first field dispersion layer, and a third protective layer comprising a third lower protective layer positioned on the second protective layer and comprising the first material, a third upper protective layer positioned on the third lower protective layer and comprising the first material, and a third interlayer protective layer positioned between the third lower protective layer and the third upper protective layer and comprising the first material, wherein the content by atomic percentage (at%) of the first material in at least one of the third lower protective layer, the third interlayer protective layer, and the third upper protective layer is greater than the content (at%) of the first material in the first protective layer.

According to an embodiment, a semiconductor device includes a channel layer; a barrier layer positioned on the channel layer and including a material having a different energy band gap from an energy band gap of the channel layer; a gate electrode positioned on the barrier layer; a gate semiconductor layer positioned between the barrier layer and the gate electrode; a first protective layer positioned on the barrier layer and covering the gate electrode; the first protective layer comprising a first material; source electrodes located on a first side of the gate electrode and connected to the channel layer; drain electrodes located on a second side opposite the first side of the gate electrode and connected to the channel layer; a first field dispersion layer, a second field dispersion layer, and a third field dispersion layer connected to the source electrode and sequentially positioned on the first protective layer; a second protective layer positioned between the first field dispersion layer and the second field dispersion layer, and a third protective layer is positioned between the second field dispersion layer and the third field dispersion layer and comprising the first material. The third protective layer includes a third lower protective layer positioned on the second field dispersion layer and the second protective layer, and a third upper protective layer positioned between the third lower protective layer and the third field dispersion layer. The content by atomic percentage (at%) of the first material in at least one of the third lower protective layer and the third upper protective layer is greater than the content (at%) of the first material in the first protective layer.

According to an embodiment, a semiconductor device includes a channel layer comprising GaN; a barrier layer positioned on the channel layer and comprising AlGaN; a gate electrode positioned on the barrier layer; a gate semiconductor layer positioned between the barrier layer and the gate electrode and including GaN doped with a p-type impurity; a first protective layer positioned on the barrier layer and covering the gate electrode, the first protective layer comprising a first material; source electrodes positioned on a first side of the gate electrode and connected to the channel layer; drain electrodes positioned on a second side opposite the first side of the gate electrode and connected to the channel layer, a first field dispersion layer, a second field dispersion layer, and a third field dispersion layer connected to the source electrodes and sequentially positioned on the first protective layer; a second protective layer positioned between the first field dispersion layer and the second field dispersion layer and comprising the first material, and a third protective layer positioned between the first field dispersion layer and the second field dispersion layer and comprising the first material. The maximum content by atomic percentage (at%) of the first material of the second protective layer is greater than the maximum content (at%) of the first material of the first protective layer and the maximum content (at%) of the first material of the third protective layer is greater than the maximum content (at%) of the first material of the second protective layer.

According to an embodiment, a method for manufacturing a semiconductor device includes the steps of forming a barrier layer including a material having a different energy band gap from a channel layer on a channel layer, forming a gate semiconductor layer and a gate electrode on the barrier layer, forming a first protective layer including a first material on the barrier layer and the gate electrode, forming a source electrode and a drain electrode penetrating the first protective layer and the barrier layer and electrically connected to the channel layer, forming a first field dispersion layer on the first protective layer, forming a second protective layer on the first protective layer and the first field dispersion layer, forming a third lower protective layer including the first material on the second protective layer, and forming a third upper protective layer including the first material on the third lower protective layer, thereby forming a third protective layer, wherein a content by atom percentage (at%) of the first material in at least one of the third lower protective layer and the third upper protective layer is greater than a content (at%) of the first material in the first protective layer.

The first material may be hydrogen(H), carbon(C), nitrogen(N), or a combination thereof.

The second protective layer may include the first material, and the content (at%) of the first material in at least one of the third lower protective layer and the third upper protective layer may be greater than the content (at%) of the first material in the second protective layer.

The content (at%) of the first material of the third lower protective layer may be greater than or equal to the content (at%) of the first material of the third upper protective layer.

The step of forming the third protective layer may further include, after forming the third lower protective layer, forming a third interlayer protective layer including the first material on the third lower protective layer, wherein the content (at%) of the first material in the third interlayer protective layer may be greater than the content (at%) of the first material in the third lower protective layer and the content (at%) of the first material in the third upper protective layer.

The third interlayer protective layer may include silicon nitride, and the third lower protective layer and the third upper protective layer may include silicon oxide.

The thickness of the third interlayer protective layer may be less than the thickness of the third lower protective layer.

According to embodiments, the reliability of semiconductor devices may be improved.

At least some of the above and other features of the invention are set out in the claims.

### BRIEF DESCRIPTION OF THE DRAWINGS

FIGS. 1 and 2 are cross-sectional views showing a semiconductor device according to an embodiment.
FIGS. 3A to 3D are graphs showing the contents of the first material of the first protective layer to the third protective layer of the semiconductor device according to an embodiment.
FIG. 4 is a cross-sectional view illustrating a semiconductor device according to some embodiments.
FIG. 5 is a cross-sectional view showing the first to third protective layers of the embodiment of FIG. 4.
FIGS. 6A to 6E are graphs showing the contents of the first material of the first to third protective layers of the semiconductor device according to the embodiment of FIG. 4.
FIG. 7 is a cross-sectional view showing the first to third protective layers according to some embodiments.
FIGS. 8 to 12 are cross-sectional views illustrating semiconductor devices according to some embodiments.
FIGS. 13 to 18 are cross-sectional views showing a process sequence for manufacturing a semiconductor device according to an embodiment.

### DETAILED DESCRIPTION

Hereinafter, various embodiments will be described in detail with reference to the attached drawings so that a person having ordinary skill in the art to which the present invention pertains may easily implement the invention. The present invention may, however, be embodied in many different forms and should not be construed as limited to the example embodiments set forth herein. It should also be emphasized that the disclosure provides details of different examples, but such listing of examples is not exhaustive. Furthermore, any consistency of detail between various examples should not be interpreted as requiring such detail. Items described in the singular herein may be provided in plural, as can be seen, for example, in the drawings. Thus, the description of a single item that is provided in plural should be understood to be applicable to the remaining plurality of items unless context indicates otherwise.

In order to clearly explain the present invention, parts that may not be related to the understanding of the inventive concept may be omitted, and the same reference numerals are used for identical or similar components throughout the specification.

In addition, the size and thickness of each component shown in the drawings are arbitrarily shown for convenience of explanation, so the present invention is not necessarily limited to what is shown. To clearly represent the various layers and areas in the drawings, the thickness may be enlarged. And in the drawings, for convenience of explanation, the thickness of some layers and areas is exaggerated.

Also, a part, such as a layer, membrane, region, or plate, described as being "over" another part may be located above or below the reference part, and does not necessarily mean being located "above" or "on" the opposite direction of gravity.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

When two conductive elements contact one another, they may be in Ohmic contact, in which current may be conducted between the two conductive elements according to Ohm's law. Ohmic contact results in the two conductive elements being electrically connected to one another. As used herein, items described as being "electrically connected" are configured such that an electrical signal can be passed from one item to the other. Therefore, a passive electrically conductive component (e.g., a wire, pad, internal electrical line, etc.) physically connected to a passive electrically insulative component (e.g., a prepreg layer of a printed circuit board, an electrically insulative adhesive connecting two device, an electrically insulative underfill or mold layer, etc.) is not electrically connected to that component.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

In the following description, when a component or layer is formed of two or more materials, the relative amount of a material may be referred to as the content by atomic percentage (at%). The content at% is a percentage representing the relative proportion of the number atoms of a material in the component or layer relative to the total number of atoms in the component or layer.

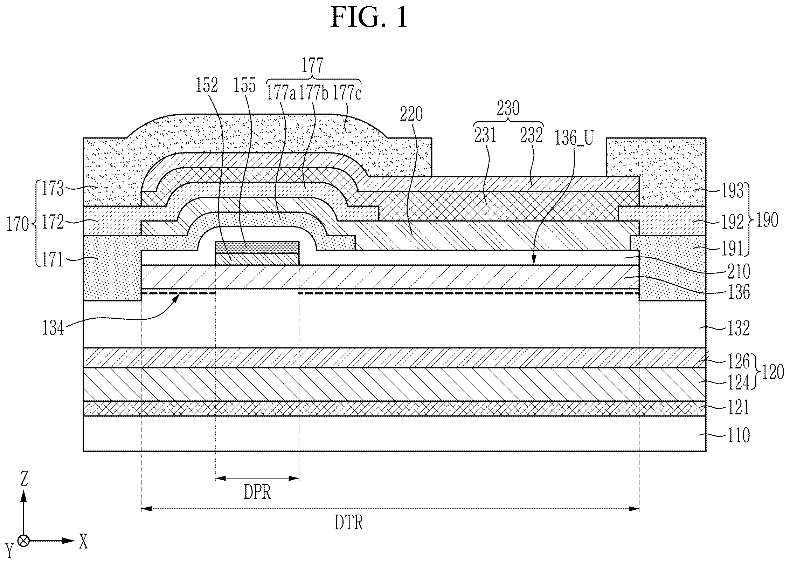

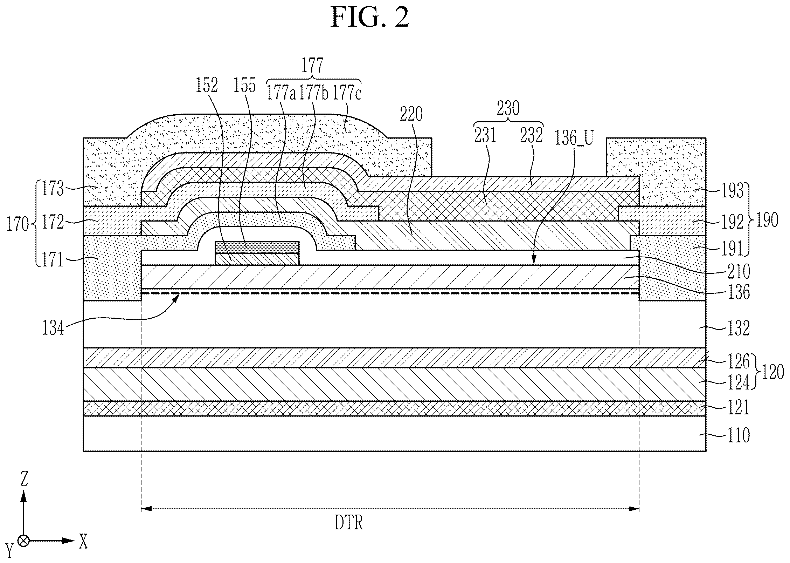

Hereinafter, a semiconductor device according to an embodiment will be described with reference to FIGS. 1 and 2.

FIGS. 1 and 2 are cross-sectional views showing a semiconductor device according to an embodiment. FIG. 1 illustrates a case where a semiconductor device according to an embodiment is in an off state, and FIG. 2 illustrates a case where a semiconductor device according to an embodiment is in an on state.

As shown in FIGS. 1 and 2, a semiconductor device according to an embodiment may include a channel layer 132, a barrier layer 136 positioned on the channel layer 132, a gate electrode 155 positioned on the barrier layer 136, a gate semiconductor layer 152 positioned between the barrier layer 136 and the gate electrode 155, a first protective layer 210 positioned on the barrier layer 136 and covering the gate electrode 155, a source electrode 170 and a drain electrode 190 positioned on opposite sides of the gate electrode 155 and connected to the channel layer 132, a first field dispersion layer 177a positioned on the first protective layer 210 and connected to the source electrode 170, a second protective layer 220 positioned on the first protective layer 210, and a third protective layer 230 positioned on the second protective layer 220.

The channel layer 132 is a layer that forms a channel between the source electrode 170 and the drain electrode 190, and a two-dimensional electron gas (2DEG) 134 may be positioned inside the channel layer 132. The two-dimensional electron gas 134 is a charge transport model used in solid-state physics, and refers to a group of electrons that may move freely in two dimensions (e.g., in an x-y plane direction, which may be directions within a horizontal plane with reference to the drawings) but are firmly confined within the two-dimensions and cannot move in another dimension (e.g., in a z direction, which may be a vertical direction with reference to the drawings). For example, the two-dimensional electron gas 134 may exist in a two-dimensional paper-like form within a three-dimensional space. This two-dimensional electron gas 134 mainly appears in a semiconductor heterojunction structure, and may occur at the interface between the channel layer 132 and the barrier layer 136 in a semiconductor device according to an embodiment. For example, a two-dimensional electron gas 134 may be generated in a portion adjacent to the barrier layer 136 within the channel layer 132.

The channel layer 132 may include one or more materials selected from Group III-V materials, for example, nitrides including Al, Ga, In, B, or combinations thereof. The channel layer 132 may be composed of a single layer or multiple layers. The channel layer 132 may be AlₓIn_{y}Ga_{1-x-y}N (0≤x≤1, 0≤y≤1, x+y≤1). For example, the channel layer 132 may include AIN, GaN, InN, InGaN, AlGaN, AlInN, AllnGaN, or a combination thereof. The channel layer 132 may be a layer doped with impurities or may be a layer that is not doped with impurities. The thickness of the channel layer 132 may be about several hundred nm or less.

The channel layer 132 may be positioned on the substrate 110, and a seed layer 121 and a buffer layer 120 may be positioned between the substrate 110 and the channel layer 132. The substrate 110, seed layer 121, and buffer layer 120 are layers that may be used in some cases for forming the channel layer 132, and may be omitted in some cases. For example, when a substrate made of GaN is used as the channel layer 132, at least one of the substrate 110, the seed layer 121, and the buffer layer 120 may be omitted. Considering that a substrate made of GaN is relatively expensive, a channel layer 132 including GaN may be grown using a substrate 110 made of Si. Furthermore, since the lattice structure of Si and the lattice structure of GaN are different, it may not be easy to grow the channel layer 132 directly on top of the substrate 110. Accordingly, a seed layer 121 and a buffer layer 120 may be grown first on a substrate 110, and then a channel layer 132 may be grown on the buffer layer 120. Additionally, at least one of the substrate 110, the seed layer 121, and the buffer layer 120 may be removed from the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited to this, and all commonly used substrates may be used in the inventive concept. In some cases, the substrate 110 may include an insulating material. For example, several layers including a channel layer 132 may be first formed on a semiconductor substrate, and then the semiconductor substrate may be removed and replaced with an insulating substrate.

The seed layer 121 may be positioned directly on the substrate 110. However, embodiments are not limited thereto, and another layer may be additionally positioned between the substrate 110 and the seed layer 121. The seed layer 121 is a layer that acts as a seed for growing the buffer layer 120 and may be formed of a crystal lattice structure that serves as the seed of the buffer layer 120. The buffer layer 120 may be positioned directly on the seed layer 121. However, embodiments are not limited to this, and another layer may be additionally positioned between the seed layer 121 and the buffer layer 120. The seed layer 121 may include one or more materials selected from Group III-V materials, for example, nitrides including Al, Ga, In, B, or a combination thereof. The seed layer 121 may be AlₓIn_{y}Ga_{1-x-y}N (0≤x≤1, 0≤y≤1, x+y≤1). For example, the seed layer 121 may include AIN, GaN, InN, InGaN, AlGaN, AlInN, AlInGaN, or a combination thereof.

The buffer layer 120 may be positioned on the seed layer 121. The buffer layer 120 may be positioned between the seed layer 121 and the channel layer 132. The buffer layer 120 may be a layer for alleviating the difference in lattice constant and thermal expansion coefficient between the seed layer 121 and the channel layer 132, or preventing leakage current from flowing through the channel layer 132. The buffer layer 120 may include one or more materials selected from Group III-V materials, for example, nitrides including Al, Ga, In, B, or a combination thereof. The buffer layer 120 may be AlₓIn_{y}Ga_{1-x-y}N (0≤x≤1, 0≤y≤1, x+y≤1). For example, the buffer layer 120 may include AIN, GaN, InN, InGaN, AlGaN, AlInN, AlInGaN, or a combination thereof.

A buffer layer 120 of a semiconductor device according to an embodiment may include a superlattice layer 124 positioned on the seed layer 121, and a high-resistance layer 126 positioned on the superlattice layer 124. The superlattice layer 124 and the high-resistance layer 126 may be sequentially positioned on the substrate 110.

The superlattice layer 124 may be positioned on the seed layer 121. The superlattice layer 124 may be positioned directly on the seed layer 121. However, embodiments are not limited thereto, and another layer may be additionally positioned between the seed layer 121 and the superlattice layer 124. The superlattice layer 124 is a layer for alleviating the difference in lattice constant and thermal expansion coefficient between the substrate 110 and the channel layer 132, thereby alleviating the tensile stress and compressive stress generated between the substrate 110 and the channel layer 132, and alleviating the stress between all layers formed by growth in the final structure of the semiconductor device according to an embodiment. The superlattice layer 124 may include one or more materials selected from Group III-V materials, for example, nitrides including Al, Ga, In, B, or combinations thereof. The superlattice layer 124 may be AlₓIn_{y}Ga_{1-x-y}N (0≤x≤1, 0≤y≤1, x+y≤1). For example, the superlattice layer 124 may include AIN, GaN, InN, InGaN, AlGaN, AlInN, AlInGaN, or a combination thereof.

In an embodiment, the superlattice layer 124 may be formed of multiple layers in which layers containing different materials are alternately stacked. For example, the superlattice layer 124 may have a structure in which layers made of AlGaN and layers made of AIN are repeatedly laminated. For example, AlGaN/AlN/AlGaN/AlN/AlGaN/AlN may be sequentially stacked to form a superlattice layer. The number of AlGaN layers and GaN constituting the superlattice layer 124 may be varied, and the material constituting the superlattice layer 124 may be varied. As another example, the superlattice layer 124 may have a structure in which layers made of AlGaN and layers made of GaN are repeatedly laminated. For example, AlGaN/GaN/AlGaN/GaN/AlGaN/GaN may be sequentially stacked to form a superlattice layer. In an embodiment, when the superlattice layer 124 includes GaN, InN, AlGaN, AlInN, InGaN, AlN, AlInGaN, or a combination thereof, the superlattice layer 124 may have n-type semiconductor characteristics in which the concentration of electrons is greater than the concentration of holes, but embodiments are not limited thereto.

The high resistance layer 126 may be positioned on the superlattice layer 124. The high resistance layer 126 may be positioned directly on the superlattice layer 124. However, embodiments are not limited thereto, and another layer may be additionally positioned between the superlattice layer 124 and the high-resistance layer 126. The high resistance layer 126 may be positioned between the superlattice layer 124 and the channel layer 132. The high resistance layer 126 is a layer that prevents the semiconductor device according to an embodiment from deteriorating by preventing leakage current from flowing through the channel layer 132. The high resistance layer 126 may be made of a material with low conductivity so that the substrate 110 and the channel layer 132 may be electrically insulated. The high-resistivity layer may include one or more materials selected from Group III-V materials, for example, nitrides including Al, Ga, In, B, or combinations thereof. The high-resistance layer 126 may be AlₓIn_{y}Ga_{1-x-y}N (0≤x≤1, 0≤y≤1, x+y≤1). For example, the high resistance layer 126 may include AIN, GaN, InN, InGaN, AlGaN, AlInN, AlInGaN, or a combination thereof. The high resistance layer 126 may be composed of a single layer or multiple layers.

The barrier layer 136 may be positioned on the channel layer 132. The barrier layer 136 may be positioned directly on the channel layer 132. However, embodiments are not limited thereto, and another layer may be additionally positioned between the channel layer 132 and the barrier layer 136. The region of the channel layer 132 overlapping the barrier layer 136 between the source electrode 170 and the drain electrode 190 may become a drift region DTR. The drift region DTR may be positioned between the source electrode 170 and the drain electrode 190. The drift region DTR may refer to a region where carriers move when a potential difference occurs between the source electrode 170 and the drain electrode 190.

The semiconductor device according to an embodiment may be turned on/off depending on whether voltage is applied to the gate electrode 155 and may depend on the magnitude of the voltage applied to the gate electrode 155, and accordingly, movement of the carrier may be achieved or blocked in the drift region DTR.

The barrier layer 136 may include one or more materials selected from Group III-V materials, for example, nitrides including Al, Ga, In, B, or combinations thereof. The barrier layer 136 may be AlₓIn_{y}Ga_{1-x-y}N (0≤x≤1, 0≤y≤1, x+y≤1). The barrier layer 136 may include GaN, InN, AlGaN, AlInN, InGaN, AlN, AlInGaN, or a combination thereof. The energy band gap of the barrier layer 136 may be controlled by the composition ratio of Al and/or In (e.g., the content at%).

The barrier layer 136 may include a semiconductor material having different characteristics from the channel layer 132. The barrier layer 136 may be different from the channel layer 132 in at least one of polarization characteristics, energy band gap, or lattice constant. For example, the barrier layer 136 may include a material having a different energy band gap from an energy band gap of the channel layer 132. In such cases, the barrier layer 136 may have a higher energy band gap than the channel layer 132 and may have a higher electric polarization rate than the channel layer 132. A two-dimensional electron gas 134 may be induced in the channel layer 132 with a relatively low electrical polarization rate by this barrier layer 136. In this regard, the barrier layer 136 may also be referred to as a channel supply layer or a two-dimensional electron gas supply layer. The two-dimensional electron gas 134 may be formed within a portion of the channel layer 132 positioned below the interface between the channel layer 132 and the barrier layer 136. The two-dimensional electron gas 134 may have very high electron mobility.

The barrier layer 136 may be composed of a single layer or multiple layers. When the barrier layer 136 is composed of multiple layers, the materials of each layer included in the multiple layers may have different energy band gaps. In such cases, the multiple layers constituting the barrier layer 136 may be arranged so that the energy band gap becomes larger the closer they are to the channel layer 132.

The gate electrode 155 may be positioned on the barrier layer 136. The gate electrode 155 may overlap a portion of the barrier layer 136 in the third direction (Z direction). The gate electrode 155 may overlap a part of the drift region DTR of the channel layer 132 in the third direction (Z direction). The gate electrode 155 may be positioned between the source electrode 170 and the drain electrode 190. The gate electrode 155 may be spaced apart from the source electrode 170 and the drain electrode 190. For example, the gate electrode 155 may be positioned closer to the source electrode 170 than it is to the drain electrode 190. Therefore, the separation distance between the gate electrode 155 and the source electrode 170 may be smaller than the separation distance between the gate electrode 155 and the drain electrode 190, but embodiments are not limited thereto. Here, the third direction (Z direction) may mean the thickness direction of the channel layer 132.

The gate electrode 155 may include a conductive material. For example, the gate electrode 155 may include a metal, a metal alloy, a conductive metal nitride, a metal silicide, a doped semiconductor material, a conductive metal oxide, or a conductive metal oxynitride. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride(NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combination thereof, but the embodiments are not thereto. The gate electrode 155 may be made of a single layer or multiple layers. The gate electrode 155 may be made of a single layer or multiple layers.

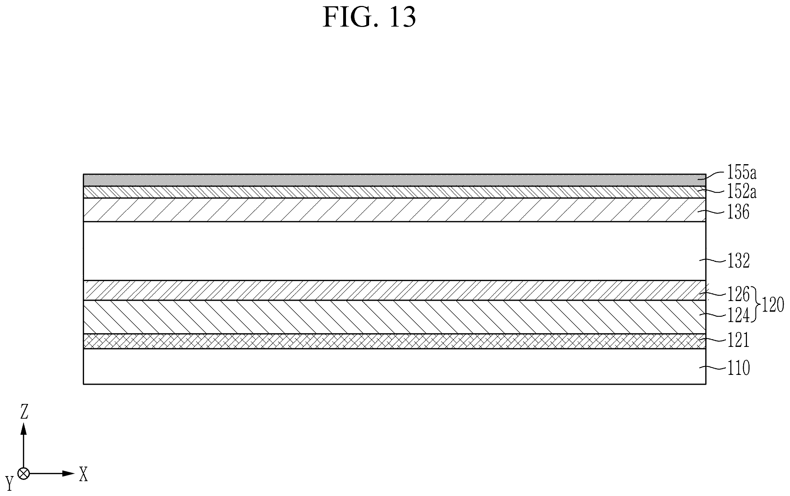

In an embodiment, a hard mask layer may further be included positioned over the gate electrode 155. The hard mask layer may be a hard mask used when patterning the gate semiconductor material layer (see 152a in FIG. 13) and the gate electrode material layer (see 155a in FIG. 13) in the process of forming the gate electrode 155. However, the hard mask layer may be removed depending on the etching conditions during the etching of the gate semiconductor material layer (see 152a in FIG. 13) or the cleaning conditions after the etching. For example, the hard mask layer may include silicon oxide, silicon nitride, silicon oxynitride, or a combination thereof.

The gate semiconductor layer 152 may be positioned between the barrier layer 136 and the gate electrode 155. The gate semiconductor layer 152 may be positioned on the barrier layer 136, and a gate electrode 155 may be positioned on the gate semiconductor layer 152. The gate electrode 155 may be in Schottky contact or ohmic contact with the gate semiconductor layer 152. The gate semiconductor layer 152 may overlap with the gate electrode 155 in the third direction (Z direction). In such cases, the gate semiconductor layer 152 may completely overlap with the gate electrode 155 in the third direction (Z direction), and the upper surface of the gate semiconductor layer 152 may be entirely covered by the gate electrode 155. For example, the gate semiconductor layer 152 may have substantially the same planar shape as a planar shape of the gate electrode 155. However, embodiments are not limited thereto, and the gate electrode 155 may be positioned to partially cover at least a portion of the gate semiconductor layer 152.

In an embodiment, the barrier layer 136 located below the gate semiconductor layer 152 within the depletion region DPR may be doped with a predetermined impurity. In such cases, the impurity doped into the barrier layer 136 may be a p-type dopant capable of providing holes. For example, the impurity doped into the barrier layer 136 may be magnesium (Mg). The threshold voltage of a semiconductor device may be controlled by increasing or decreasing the impurity doping concentration of the barrier layer 136. The barrier layer 136 may be doped with a predetermined impurity. In such cases, the impurity doped into the barrier layer 136 may be a p-type dopant capable of providing holes. For example, the impurity doped into the barrier layer 136 may be magnesium (Mg). By increasing or decreasing the impurity doping concentration of the barrier layer 136, the threshold voltage, on-resistance, etc. of the semiconductor device according to an embodiment may be controlled.

The gate semiconductor layer 152 may be positioned between the source electrode 170 and the drain electrode 190. The gate semiconductor layer 152 may be spaced apart from the source electrode 170 and the drain electrode 190. The gate semiconductor layer 152 may be positioned closer to the source electrode 170 than to the drain electrode 190. For example, the separation distance between the gate semiconductor layer 152 and the source electrode 170 may be smaller than the separation distance between the gate semiconductor layer 152 and the drain electrode 190, but embodiments are not limited thereto.

In an embodiment, the gate semiconductor layer 152 may overlap the gate electrode 155 in the third direction (Z direction). For example, the gate semiconductor layer 152 may completely overlap the gate electrode 155 in the third direction (Z direction). For example, the side surface of the gate semiconductor layer 152 may be aligned with the side surface of the gate electrode 155. However, embodiments are not limited thereto, and the gate semiconductor layer 152 may partially overlap with the gate electrode 155.

The gate semiconductor layer 152 may include one or more materials selected from Group III-V materials, for example, nitrides including Al, Ga, In, B, or a combination thereof. The gate semiconductor layer 152 may be AlₓIn_{y}Ga_{1-x-y}N (0≤x≤1, 0≤y≤1, x+y≤1). For example, the gate semiconductor layer 152 may include AIN, GaN, InN, InGaN, AlGaN, AlInN, AlInGaN, or a combination thereof. The gate semiconductor layer 152 may include a material having a different energy band gap from the barrier layer 136. For example, the gate semiconductor layer 152 may include GaN, and the barrier layer 136 may include AlGaN. The gate semiconductor layer 152 may be doped with a predetermined impurity. In such cases, the impurity doped into the gate semiconductor layer 152 may be a p-type dopant capable of providing holes. For example, the gate semiconductor layer 152 may include GaN doped with p-type impurities. For example, the gate semiconductor layer 152 may be made of a p-GaN layer. However, embodiments are not limited thereto, and for example, the gate semiconductor layer 152 may be a p-AlGaN layer. As another example, the gate semiconductor layer 152 may be formed of multiple layers including a p-GaN layer and a p-AlGaN layer.

A depletion region DPR may be formed within the channel layer 132 by the gate semiconductor layer 152. The depletion region DPR may be positioned within the drift region DTR and may have a narrower width than a width of the drift region DTR. As a gate semiconductor layer 152 having an energy band gap different from that of the barrier layer 136 is positioned on the barrier layer 136, the energy band level of a portion of the barrier layer 136 overlapping the gate semiconductor layer 152 may be raised. Accordingly, a depletion region DPR may be formed in the region of the channel layer 132 overlapping the gate semiconductor layer 152. The depletion region DPR may be a region in the channel path of the channel layer 132 where a two-dimensional electron gas 134 is not formed or has a lower electron concentration than the remaining region. For example, the depletion region DPR may mean a region where the flow of two-dimensional electron gas 134 is cut off within the drift region DTR. As the depletion region DPR occurs, current does not flow between the source electrode 170 and the drain electrode 190, and the channel path may be blocked. Accordingly, the semiconductor device according to an embodiment may have normally-off characteristics.

For example, the semiconductor device according to an embodiment may be a normally-off high electron mobility transistor (HEMT). As shown in FIG. 1, in a normal state where no voltage is applied to the gate electrode 155, a depletion region DPR exists, and the semiconductor device according to an embodiment may be in an off state. As shown in FIG. 2, when a voltage higher than the threshold voltage is applied to the gate electrode 155, the depletion region DPR disappears, and the two-dimensional electron gas 134 may be connected without being disconnected within the drift region DTR. For example, a two-dimensional electron gas 134 may be formed throughout the channel path between the source electrode 170 and the drain electrode 190, and the semiconductor device according to an embodiment may be in an on state. For example, a semiconductor device according to an embodiment may include semiconductor layers having different electrical polarization characteristics, and a semiconductor layer having a relatively large polarization rate may induce a two-dimensional electron gas 134 in another semiconductor layer heterojunction therewith. This two-dimensional electron gas 134 may be used as a channel between the source electrode 170 and the drain electrode 190, and the flow of this two-dimensional electron gas 134 may be continued or interrupted by the bias voltage applied to the gate electrode 155. In the gate-off state, the flow of two-dimensional electron gas 134 is blocked, so that current does not flow between the source electrode 170 and the drain electrode 190. As the flow of two-dimensional electron gas 134 continues in the gate-on state, current may flow between the source electrode 170 and the drain electrode 190.

In the above, the semiconductor device according to an embodiment is described as a normally-off high electron mobility transistor, but embodiments are not limited thereto. For example, a semiconductor device according to an embodiment may be a normally-on high electron mobility transistor. In the case of a normally-on high electron mobility transistor, the gate semiconductor layer 152 may be omitted, and thus the gate electrode 155 may be positioned directly on the barrier layer 136. For example, the gate electrode 155 may come into contact with the barrier layer 136. However, embodiments are not limited thereto, and a gate insulating layer may be additionally positioned between the gate electrode 155 and the barrier layer 136. The insulating layer may be composed of a single layer or multiple layers. In such cases, the gate insulating layer may completely overlap the gate electrode 155 in the third direction (Z direction), but embodiments are not limited thereto.

In this structure, a two-dimensional electron gas 134 may be used as a channel when no voltage is applied to the gate electrode 155, and a current flow may occur between the source electrode 170 and the drain electrode 190. Additionally, when a negative voltage is applied to the gate electrode 155, a depletion region DPR may occur in which the flow of two-dimensional electron gas 134 is cut off at the bottom of the gate electrode 155.

The seed layer 121, superlattice layer 124, high-resistance layer 126, channel layer 132, barrier layer 136, and gate semiconductor layer 152 may be sequentially stacked on the substrate 110. In a semiconductor device according to an embodiment, at least one of the seed layer 121, the superlattice layer 124, the high-resistance layer 126, the channel layer 132, the barrier layer 136, and the gate semiconductor layer 152 may be omitted. These seed layer 121, superlattice layer 124, high-resistance layer 126, channel layer 132, barrier layer 136, and gate semiconductor layer 152 may be made of the same base semiconductor material, and the material composition ratio of each layer may be different in consideration of the role of each layer, performance required for the semiconductor device, etc.

The first protective layer 210 may be positioned on the barrier layer 136. The first protective layer 210 may cover the gate electrode 155. For example, the first protective layer 210 may be positioned directly on the upper surface 136_U of the barrier layer 136. The first protective layer 210 may cover the upper surface and side surface of the gate electrode 155 and the side surface of the gate semiconductor layer 152. The lower surface of the first protective layer 210 may be in contact with the upper surface 136_U of the barrier layer 136, the side surface of the gate electrode 155, and the upper surface of the gate electrode 155. Accordingly, the barrier layer 136, the gate semiconductor layer 152, and the gate electrode 155 may be protected by the first protective layer 210. However, embodiments are not limited thereto, and the gate electrode 155 may penetrate the first protective layer 210 and be connected to the gate semiconductor layer 152, and the first protective layer 210 may not cover the upper surface of the gate electrode 155. Alternatively, the lower surface of the first protective layer 210 may be in contact with the gate semiconductor layer 152.

Additionally, the first protective layer 210 may be positioned on the side surface of the source electrode 170 and the side surface of the drain electrode 190. For example, the first protective layer 210 may cover at least a portion of the side surface of the source electrode 170 and the side surface of the drain electrode 190.

The first protective layer 210 may include an insulating material. For example, the first protective layer 210 may include an oxide such as silicon oxide (SiO₂) or aluminum oxide (Al₂O₃), but embodiments are not limited thereto. As another example, the first protective layer 210 may include a nitride, such as silicon nitride (SiN), or an oxynitride, such as silicon oxynitride (SiON).

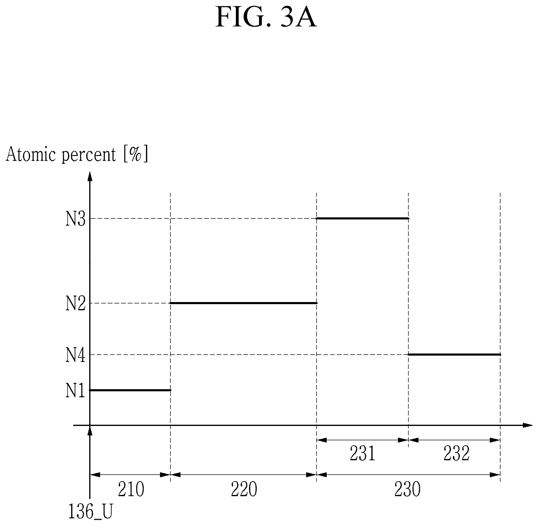

The first protective layer 210 may include a first material. The first material may be hydrogen(H), carbon(C), nitrogen(N), or a combination thereof. In an embodiment, the first protective layer 210 may include a first material having a first content (at%). In an embodiment, the first content (at%) of the first material of the first protective layer 210 may be constant as it increases away from the upper surface 136_U of the barrier layer 136, but embodiments are not limited thereto. For example, the first content (at%) of the first material of the first protective layer 210 may increase with distance from the upper surface 136_U of the barrier layer 136. As another example, the first content (at%) of the first material of the first protective layer 210 may include a portion that decreases with distance from the upper surface 136_U of the barrier layer 136. Additionally, the first content (at%) of the first material of the first protective layer 210 may be different from the content (at%) of the first material of the second protective layer 220 and the content (at%) of the first material of the third protective layer 230. This is described with reference to Figs. 3a to 3d later.

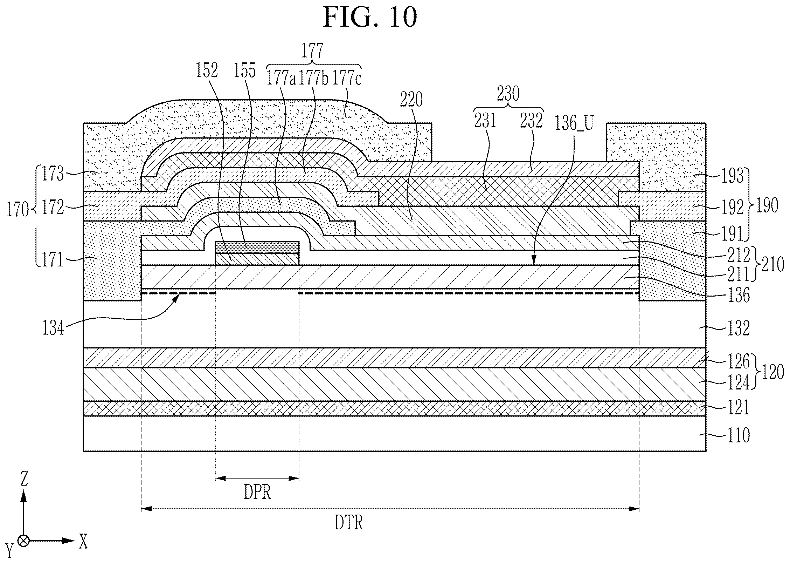

In FIGS. 1 and 2, the first protective layer 210 is shown as being formed of a single layer, but is not limited thereto, and the first protective layer 210 may be formed of two or more multilayers having different contents (at%) of the first material. This is described with reference to Fig. 10 later.

The source electrode 170 and the drain electrode 190 may be positioned on the channel layer 132. The source electrode 170 and the drain electrode 190 may be in contact with the channel layer 132 and electrically connected to the channel layer 132.

The source electrode 170 and the drain electrode 190 may extend in the second direction (Y direction). The source electrode 170 and the drain electrode 190 may be spaced apart from each other, and a gate electrode 155 and a gate semiconductor layer 152 may be positioned between the source electrode 170 and the drain electrode 190. The gate electrode 155 and the gate semiconductor layer 152 may be spaced apart from the source electrode 170 and the drain electrode 190. For example, the source electrode 170 may be electrically connected to the channel layer 132 on one side of the gate electrode 155, and the drain electrode 190 may be electrically connected to the channel layer 132 on the other side of the gate electrode 155. The source electrode 170 and the drain electrode 190 may be positioned outside the drift region DTR of the channel layer 132. The interface between the source electrode 170 and the channel layer 132 may be one edge of a drift region DTR. Similarly, the interface between the drain electrode 190 and the channel layer 132 may be the other edge of the drift region DTR.

However, embodiments are not limited thereto, and the channel layer 132 may not be recessed, and the source electrode 170 and the drain electrode 190 may be positioned on the upper surface of the channel layer 132 and/or the upper surface 136_U of the barrier layer 136. In this case, the bottom surfaces of the source electrode 170 and the drain electrode 190 may be in contact with the upper surface of the channel layer 132 and the upper surface 136_U of the barrier layer or a portion of the partially recessed barrier layer 136. A portion of the channel layer 132 or a portion of the barrier layer 136 in contact with the source electrode 170 and the drain electrode 190 may be highly doped. For example, the portion of the channel layer 132 or the portion of the barrier layer 136 in contact with the source electrode 170 and the drain electrode 190 may be heavily doped with an N-type dopant. In such cases, carriers passing through the two-dimensional electron gas 134 may be transferred to the source electrode 170 and the drain electrode 190 through a portion of the channel layer 132 or a portion of the barrier layer 136 that is doped at a high concentration, for example, the upper portion of the two-dimensional electron gas 134. The source electrode 170 and the drain electrode 190 may not be in contact with the two-dimensional electron gas 134 in the horizontal direction. Here, the horizontal direction may mean a direction parallel to the upper surface 136_U of the channel layer 132 or the barrier layer 136.

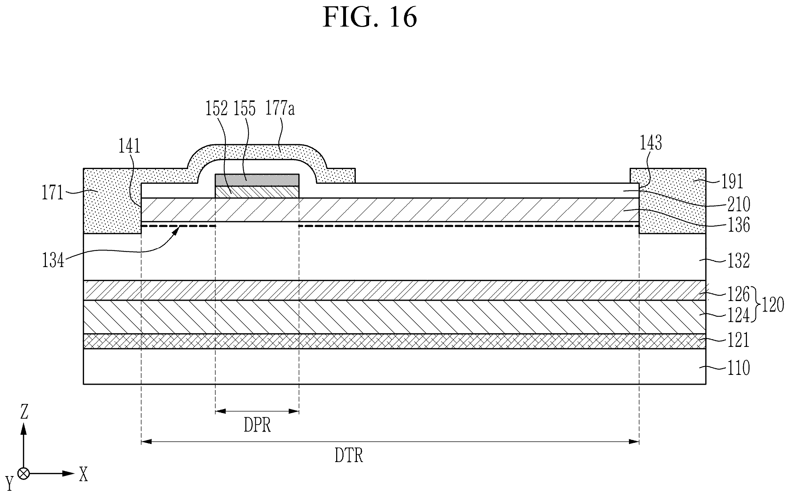

Specifically, trenches (see 141, 143 in FIG. 16) penetrating the first protective layer 210 and the barrier layer 136 and recessing the upper surface of the channel layer 132 may be positioned spaced apart from each other on opposite sides of the gate electrode 155. The source electrode 170 and a drain electrode 190 may be positioned in trenches (see 141, 143 in FIG. 16) located on opposite sides of the gate electrode 155, respectively. The source electrode 170 and the drain electrode 190 may be formed to fill the trenches (see 141, 143 of FIG. 16). Within the trenches, the source electrode 170 and the drain electrode 190 may be in contact with the channel layer 132 and the barrier layer 136. The channel layer 132 may form the bottom surface and side walls of the trench, and the barrier layer 136 may form the side walls of the trench. Additionally, the source electrode 170 and the drain electrode 190 may be in contact with the side surface of the barrier layer 136. For example, the source electrode 170 and the drain electrode 190 may cover the side surfaces of the channel layer 132 and the barrier layer 136.

The source electrode 170 and the drain electrode 190 may include a conductive material. For example, the source electrode 170 and the drain electrode 190 may include a metal, a metal alloy, a conductive metal nitride, a metal silicide, a doped semiconductor material, a conductive metal oxide, or a conductive metal oxynitride. For example, the source electrode 170 and the drain electrode 190 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride(NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combination thereof, but the embodiments are not thereto. The source electrode 170 and the drain electrode 190 may be made of a single layer or multiple layers. The source electrode 170 and the drain electrode 190 may be in ohmic contact with the channel layer 132. The region in contact with the source electrode 170 and the region in contact with the drain electrode 190 within the channel layer 132 and the barrier layer 136 may be doped at a relatively high concentration compared to other regions.

According to an embodiment, the source electrode 170 of the semiconductor device may include a plurality of source electrodes 171, 172, and 173 sequentially stacked in a third direction (Z direction) on the channel layer 132, and the drain electrode 190 may include a plurality of drain electrodes 191, 192, and 193 sequentially stacked in a third direction (Z direction) on the channel layer 132.

The first source electrode 171 and the first drain electrode 191 may penetrate the first protective layer 210 and the barrier layer 136. The first source electrode 171 and the first drain electrode 191 may be in contact with the channel layer 132. In an embodiment, the first source electrode 171 and the first drain electrode 191 may be positioned on the side surface of the barrier layer 136 and the side surface of the first protective layer 210. The first source electrode 171 and the first drain electrode 191 may cover a portion of the side surface of the barrier layer 136 and the side surface of the first protective layer 210. The upper surfaces of the first source electrode 171 and the first drain electrode 191 may protrude in the third direction (Z direction) more than the upper surface of the first protective layer 210. Additionally, at least one of the first source electrode 171 and the first drain electrode 191 may cover at least a portion of the upper surface of the first protective layer 210, but embodiments are not limited thereto.

The second source electrode 172 may be positioned on the first source electrode 171. The second source electrode 172 may be in contact with the first source electrode 171. The second source electrode 172 may be positioned on the side surface of the second protective layer 220 to be described later. The second source electrode 172 may be in contact with the second protective layer 220 to be described later. In an embodiment, the second source electrode 172 may cover at least a portion of the upper surface of the second protective layer 220, which will be described later, but embodiments are not limited thereto. The second source electrode 172 may include a conductive material. The second source electrode 172 may include the same conductive material as the first source electrode 171, but embodiments are not limited thereto. As another example, the second source electrode 172 may include a different conductive material than the first source electrode 171.

The third source electrode 173 may be positioned on the second source electrode 172. The third source electrode 173 may be in contact with the second source electrode 172. The third source electrode 173 may be positioned on the side surface of the third protective layer 230 to be described later. The third source electrode 173 may be in contact with the third protective layer 230 to be described later. The third source electrode 173 may cover at least a portion of the upper surface of the third protective layer 230 to be described later, but embodiments are not limited thereto. The third source electrode 173 may include a conductive material. The third source electrode 173 may include the same conductive material as the first source electrode 171 and the second source electrode 172, but embodiments are not limited thereto. As another example, the third source electrode 173 may include a different conductive material than the first source electrode 171 and the second source electrode 172.

The second drain electrode 192 may be positioned on the first drain electrode 191. The second drain electrode 192 may be in contact with the first drain electrode 191. The second drain electrode 192 may be positioned on the side surface of the second protective layer 220 to be described later. The second drain electrode 192 may be in contact with the second protective layer 220 to be described later. The second drain electrode 192 may cover at least a portion of the upper surface of the second protective layer 220 to be described later, but embodiments are not limited thereto. The second drain electrode 192 may include a conductive material. The second drain electrode 192 may include the same conductive material as the first drain electrode 191, but embodiments are not limited thereto. As another example, the second drain electrode 192 may include a different conductive material than the first drain electrode 191.

The third drain electrode 193 may be positioned on the second drain electrode 192. The third drain electrode 193 may be in contact with the second drain electrode 192. The third drain electrode 193 may be positioned on the side surface of the third protective layer 230 to be described later. The third drain electrode 193 may be in contact with the third protective layer 230 to be described later. The third drain electrode 193 may cover at least a portion of the upper surface of the third protective layer 230 to be described later, but embodiments are not limited thereto. The third drain electrode 193 may include a conductive material. The third drain electrode 193 may include the same conductive material as the first drain electrode 191 and the second drain electrode 192, but embodiments are not limited thereto. As another example, the third drain electrode 193 may include a different conductive material from the first drain electrode 191 and the second drain electrode 192.

The field dispersion layer 177 may be positioned between the gate electrode 155 and the drain electrode 190. The field dispersion layer 177 may be positioned between the source electrode 170 and the drain electrode 190. The field dispersion layer 177 may overlap with the gate electrode 155, the gate semiconductor layer 152, and the channel layer 132 in the third direction (Z direction).

A field dispersion layer 177 of a semiconductor device according to an embodiment may include a first field dispersion layer 177a, a second field dispersion layer 177b, and a third field dispersion layer 177c sequentially positioned in a third direction (Z direction).

The first field dispersion layer 177a may be positioned on the first protective layer 210. The first field dispersion layer 177a may be positioned directly on the upper surface of the first protective layer 210. The first field dispersion layer 177a may be positioned between the first protective layer 210 and the second protective layer 220 to be described later. The lower surface of the first field dispersion layer 177a may be in contact with the first protective layer 210. The first field dispersion layer 177a may extend in the first direction (X direction). For example, the first field dispersion layer 177a may extend in a first direction (X direction) from one side surface of the first source electrode 171 toward the first drain electrode 191.

The first field dispersion layer 177a may include the same material as the first source electrode 171 and may be positioned in the same layer as the first source electrode 171. For example, at least a portion of the first field dispersion layer 177a and the first source electrode 171 may be positioned over the first protective layer 210. At least a portion of the first field dispersion layer 177a and the first source electrode 171 may be positioned directly on the upper surface of the first protective layer 210. At least a portion of the first field dispersion layer 177a and the first source electrode 171 may be positioned between the first protective layer 210 and the second protective layer 220. The first field dispersion layer 177a may be formed simultaneously with the first source electrode 171 in the same process. For example, the boundary between the first field dispersion layer 177a and the first source electrode 171 is not clear, and the first field dispersion layer 177a may be formed integrally with the first source electrode 171. However, embodiments are not limited thereto, and the first field dispersion layer 177a may be a separate component separated from the first source electrode 171. For example, the first field dispersion layer 177a may be positioned spaced apart from the first source electrode 171 in the first direction (X direction). Additionally, the first field dispersion layer 177a may be positioned in a different layer from the first source electrode 171 and may be formed in a different process.

The second field dispersion layer 177b may be positioned on the first field dispersion layer 177a. The second field dispersion layer 177b may be positioned spaced apart from the first field dispersion layer 177a in the third direction (Z direction). For example, a second protective layer 220, which will be described later, may be positioned between the second field dispersion layer 177b and the first field dispersion layer 177a. The second field dispersion layer 177b may be positioned on the second protective layer 220. The second field dispersion layer 177b may be positioned directly on the upper surface of the second protective layer 220. The second field dispersion layer 177b may be positioned between the second protective layer 220 and the third protective layer 230 to be described later. The lower surface of the second field dispersion layer 177b may be in contact with the second protective layer 220 to be described later. The upper surface of the second field dispersion layer 177b may be in contact with the third protective layer 230 to be described later.

The second field dispersion layer 177b may extend in the first direction (X direction). For example, the second field dispersion layer 177b may extend in the first direction (X direction) from one side surface of the second source electrode 172 toward the second drain electrode 192. The length of the second field dispersion layer 177b along the first direction (X direction) may be greater than the length of the first field dispersion layer 177a along the first direction (X direction). One end of the second field dispersion layer 177b may protrude further toward the drain electrode 190 than one end of the first field dispersion layer 177a. For example, one end of the second field dispersion layer 177b may be positioned closer to the drain electrode 190 than one end of the first field dispersion layer 177a.

The second field dispersion layer 177b may include the same material as the second source electrode 172 and may be positioned in the same layer as the second source electrode 172. For example, at least a portion of the second field dispersion layer 177b and the second source electrode 172 may be positioned over the second protective layer 220. At least a portion of the second field dispersion layer 177b and the second source electrode 172 may be positioned directly on the upper surface of the second protective layer 220. At least a portion of the second field dispersion layer 177b and the second source electrode 172 may be positioned between the second protective layer 220 and the third protective layer 230. The second field dispersion layer 177b may be formed simultaneously with the second source electrode 172 in the same process. For example, the boundary between the second field dispersion layer 177b and the second source electrode 172 is not clear, and the second field dispersion layer 177b may be formed integrally with the second source electrode 172. However, embodiments are not limited thereto, and the second field dispersion layer 177b may be a separate component separated from the second source electrode 172. For example, the second field dispersion layer 177b may be positioned spaced apart from the second source electrode 172 in the first direction (X direction). Additionally, the second field dispersion layer 177b may be positioned in a different layer from the second source electrode 172 and may be formed in a different process.

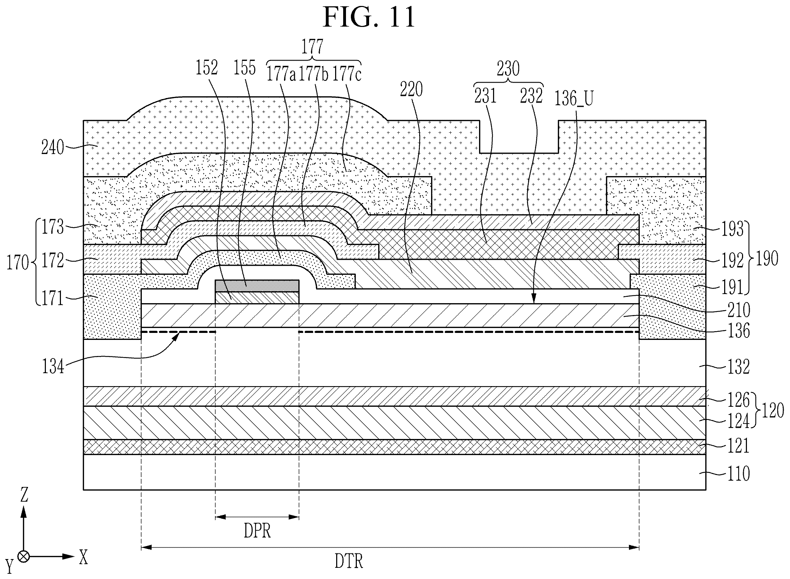

The third field dispersion layer 177c may be positioned on the second field dispersion layer 177b. The third field dispersion layer 177c may be positioned spaced apart from the second field dispersion layer 177b in the third direction (Z direction). For example, a third protective layer 230, which will be described later, may be positioned between the third field dispersion layer 177c and the second field dispersion layer 177b. The third field dispersion layer 177c may be positioned on the third protective layer 230. The third field dispersion layer 177c may be positioned directly on the upper surface of the third protective layer 230. The third field dispersion layer 177c may be positioned between the third protective layer 230 and the capping layer (see 240 in FIG. 11) to be described later. The lower surface of the third field dispersion layer 177c may be in contact with the third protective layer 230 to be described later.

The third field dispersion layer 177c may extend in the first direction (X direction). For example, the third field dispersion layer 177c may extend in the first direction (X direction) from one side surface of the third source electrode 173 toward the third drain electrode 193. The length of the third field dispersion layer 177c along the first direction (X direction) may be greater than the length of the second field dispersion layer 177b along the first direction (X direction). One end of the third field dispersion layer 177c may protrude further toward the drain electrode 190 than one end of the second field dispersion layer 177b. For example, one end of the third field dispersion layer 177c may be positioned closer to the drain electrode 190 than one end of the second field dispersion layer 177b.

The third field dispersion layer 177c may include the same material as the third source electrode 173 and may be positioned in the same layer as the third source electrode 173. For example, at least a portion of the third field dispersion layer 177c and the third source electrode 173 may be positioned on the third protective layer 230. At least a portion of the third field dispersion layer 177c and the third source electrode 173 may be positioned directly on the upper surface of the third protective layer 230. The third field dispersion layer 177c may be formed simultaneously with the third source electrode 173 in the same process. For example, the boundary between the third field dispersion layer 177c and the third source electrode 173 is not clear, and the third field dispersion layer 177c may be formed integrally with the third source electrode 173. However, embodiments are not limited thereto, and the third field dispersion layer 177c may be a separate component separated from the third source electrode 173. For example, the first field dispersion layer 177a may be positioned spaced apart from the first source electrode 171 in the first direction (X direction). Additionally, the third field dispersion layer 177c may be positioned in a different layer from the third source electrode 173 and may be formed in a different process.

A plurality of field dispersion layers 177a, 177b, and 177c may serve to disperse the electric field concentrated around the gate electrode 155. Specifically, when a high voltage is applied to the drain electrode 190 in the gate-off state, a two-dimensional electron gas 134 may be positioned at a very high concentration in the channel layer 132 portion located between the gate electrode 155 and the drain electrode 190. In this case, an electric field may be concentrated at the edge of the gate electrode 155 or the gate semiconductor layer 152 close to the drain electrode 190. The gate electrode 155 and the gate semiconductor layer 152 are vulnerable to electric fields, and when the electric field is concentrated, leakage current may increase and the breakdown voltage of the semiconductor element may decrease. In such cases, the electric field concentrated around the gate electrode 155 or the gate semiconductor layer 152 is dispersed by the multiple field dispersion layers 177a, 177b, and 177c, so that the leakage current may be reduced and the breakdown voltage may be increased. In particular, since the distance along the first direction (X direction) between one end of the second field dispersion layer 177b and the second drain electrode 192 is smaller than the distance along the first direction (X direction) between one end of the first field dispersion layer 177a and the first drain electrode 191, and since the distance along the first direction (X direction) between one end of the third field dispersion layer 177c and the third drain electrode 193 is smaller than the distance along the first direction (X direction) between one end of the second field dispersion layer 177b and the second drain electrode 192, an electric field concentrated around the gate electrode 155 or the gate semiconductor layer 152 may be effectively dispersed.

In FIGS. 1 and 2, a semiconductor device according to an embodiment is illustrated as including three field dispersion layers 177a, 177b, and 177c, but the number of field dispersion layers 177 is not limited thereto.

The second protective layer 220 may be positioned on the first protective layer 210. The second protective layer 220 may be positioned directly on the first protective layer 210. The second protective layer 220 may cover the first protective layer 210 and the first field dispersion layer 177a. The second protective layer 220 may be positioned between the first field dispersion layer 177a and the second field dispersion layer 177b. The lower surface of the second protective layer 220 may be in contact with the first protective layer 210 and the first field dispersion layer 177a, and the upper surface of the second protective layer 220 may be in contact with the second field dispersion layer 177b. Additionally, the second protective layer 220 may be positioned on the side surface of the source electrode 170 and the side surface of the drain electrode 190. For example, the second protective layer 220 may be positioned on the side surface of the second source electrode 172 and the side surface of the second drain electrode 192. The second protective layer 220 may cover at least a portion of the side surface of the second source electrode 172 and the side surface of the second drain electrode 192. The second protective layer 220 may be positioned on the side surface of the first source electrode 171 and the side surface of the first drain electrode 191, but embodiments are not limited thereto. The thickness of the second protective layer 220 along the third direction (Z direction) may be greater than the thickness of the first protective layer 210 along the third direction (Z direction), but embodiments are not limited thereto.

The second protective layer 220 may include an insulating material. The second protective layer 220 may include the same material as the first protective layer 210, but embodiments are not limited thereto. For example, the second protective layer 220 may include an oxide such as silicon oxide (SiO₂) or aluminum oxide (Al₂O₃), but embodiments are not limited thereto. As another example, the second protective layer 220 may include a nitride, such as silicon nitride (SiN), or a nitride, such as silicon oxynitride (SiON).

The second protective layer 220 may include the first material. In an embodiment, the second protective layer 220 may include a second content (at%) of the first material. The second content (at%) of the first material of the second protective layer 220 may be greater than the first content (at%) of the first material of the first protective layer 210. The second content (at%) of the first material of the second protective layer 220 may be constant as it increases away from the upper surface 136_U of the barrier layer 136, but embodiments are not limited thereto. For example, the second content (at%) of the first material of the second protective layer 220 may increase with distance from the upper surface 136_U of the barrier layer 136. As another example, the second content (at%) of the first material of the second protective layer 220 may include a portion that decreases with distance from the upper surface 136_U of the barrier layer 136. A detailed description of this will be given later in Figs. 3a to 3d.

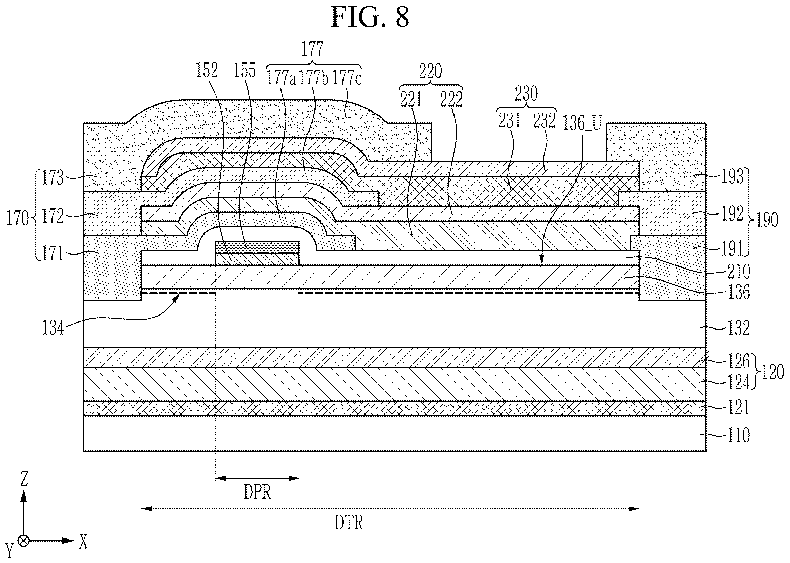

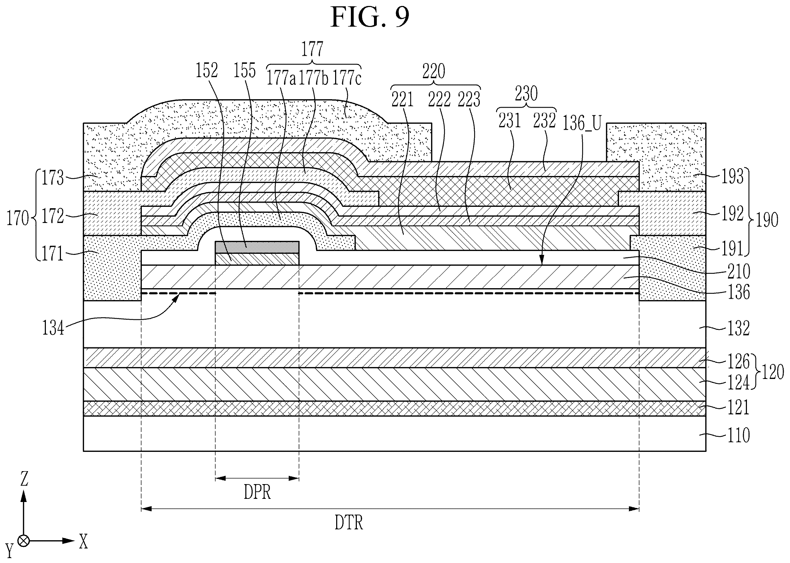

In FIGS. 1 and 2, the second protective layer 220 is illustrated as being formed of a single layer, but is not limited thereto, and the second protective layer 220 may be formed of two or more multilayers having different contents (at%) of the first material. An explanation of this will be provided later with reference to FIGS. 8 and 9.

The third protective layer 230 may be positioned on the second protective layer 220. The third protective layer 230 may be positioned directly on the second protective layer 220. The third protective layer 230 may cover the second protective layer 220 and the second field dispersion layer 177b. The third protective layer 230 may be positioned between the second field dispersion layer 177b and the third field dispersion layer 177c. The lower surface of the third protective layer 230 may be in contact with the second protective layer 220 and the second field dispersion layer 177b, and the upper surface of the third protective layer 230 may be in contact with the third field dispersion layer 177c. Additionally, the third protective layer 230 may be positioned on the side surface of the source electrode 170 and the side surface of the drain electrode 190. For example, the third protective layer 230 may be positioned on the side surface of the third source electrode 173 and the side surface of the third drain electrode 193. The third protective layer 230 may cover at least a portion of the side surface of the third source electrode 173 and the side surface of the third drain electrode 193. The third protective layer 230 may be positioned on the side surface of the second source electrode 172 and the side surface of the second drain electrode 192, but embodiments are not limited thereto. The thickness of the third protective layer 230 along the third direction (Z direction) may be greater than the thickness of the second protective layer 220 along the third direction (Z direction).

The third protective layer 230 may include the first material. In an embodiment, the third protective layer 230 may include a portion in which the content (at%) of the first material of the third protective layer 230 is greater than the first content (at%) of the first material of the first protective layer 210. In an embodiment, the third protective layer 230 may include a portion in which the content (at%) of the first material of the third protective layer 230 is greater than the second content (at%) of the first material of the second protective layer 220 (e.g., the maximum content (at%) may refer to the content (at%) of a portion of a component having the greatest content (at%) within the component). In this case, the maximum content (at%) of the first material of the third protective layer 230 may be greater than the maximum content (at%) of the first material of the first protective layer 210. The maximum content (at%) of the first material of the third protective layer 230 may be greater than the maximum content (at%) of the first material of the second protective layer 220. A detailed description of this will be described later with reference to FIGS. 3a to 3d.

A third protective layer 230 of a semiconductor device according to an embodiment may include a third lower protective layer 231 positioned over a second protective layer 220 and a third upper protective layer 232 positioned over the third lower protective layer 231.

The third lower protective layer 231 may be positioned on the second protective layer 220 and the second field dispersion layer 177b. The third lower protective layer 231 may be positioned directly on the second protective layer 220. The third lower protective layer 231 may cover the second field dispersion layer 177b. The lower surface of the third lower protective layer 231 may be in contact with the second protective layer 220 and the second field dispersion layer 177b.

The third lower protective layer 231 may include an insulating material. The third lower protective layer 231 may include the same material as the first protective layer 210 and the second protective layer 220, but embodiments are not limited thereto. For example, the third lower protective layer 231 may include, but is not limited to, an oxide such as silicon oxide (SiO₂) or aluminum oxide (Al₂O₃). As another example, the third lower protective layer 231 may include a nitride, such as silicon nitride (SiN), or a nitride, such as silicon oxynitride (SiON).

The third lower protective layer 231 may include the first material. The third lower protective layer 231 may include a third content (at%) of the first material. The third content (at%) of the first material of the third lower protective layer 231 may be greater than the first content (at%) of the first material of the first protective layer 210. The third content (at%) of the first material of the third lower protective layer 231 may be greater than the second content (at%) of the first material of the second protective layer 220. However, embodiments are not limited thereto, and the third content (at%) of the first material of the third lower protective layer 231 may be less than or equal to the second content (at%) of the first material of the second protective layer 220. An explanation of this will be provided later with reference to FIGS. 3a to 3d.

The third upper protective layer 232 may be positioned on the third lower protective layer 231. The third upper protective layer 232 may be positioned between the third lower protective layer 231 and the third field dispersion layer 177c. The upper surface of the third upper protective layer 232 may be in contact with the third field dispersion layer 177c.

The third upper protective layer 232 may include an insulating material. The third upper protective layer 232 may include, but is not limited to, the same material as the third lower protective layer 231. The third upper protective layer 232 may include the same material as the first protective layer 210 and the second protective layer 220, but embodiments are not limited thereto. For example, the third upper protective layer 232 may include, but is not limited to, an oxide such as silicon oxide (SiO₂) or aluminum oxide (Al₂O₃). As another example, the third upper protective layer 232 may include a nitride, such as silicon nitride (SiN), or a nitride, such as silicon oxynitride (SiON).

The third upper protective layer 232 may include the first material. The third upper protective layer 232 may include a fourth content (at%) of the first material. The fourth content (at%) of the first material of the third upper protective layer 232 may be greater than the first content (at%) of the first material of the first protective layer 210. The fourth content (at%) of the first material of the third upper protective layer 232 may be greater than the second content (at%) of the first material of the second protective layer 220. However, embodiments are not limited thereto, and the fourth content (at%) of the first material of the third upper protective layer 232 may be less than or equal to the second content (at%) of the first material of the second protective layer 220. An explanation of this will be provided later with reference to FIGS. 3a to 3d.

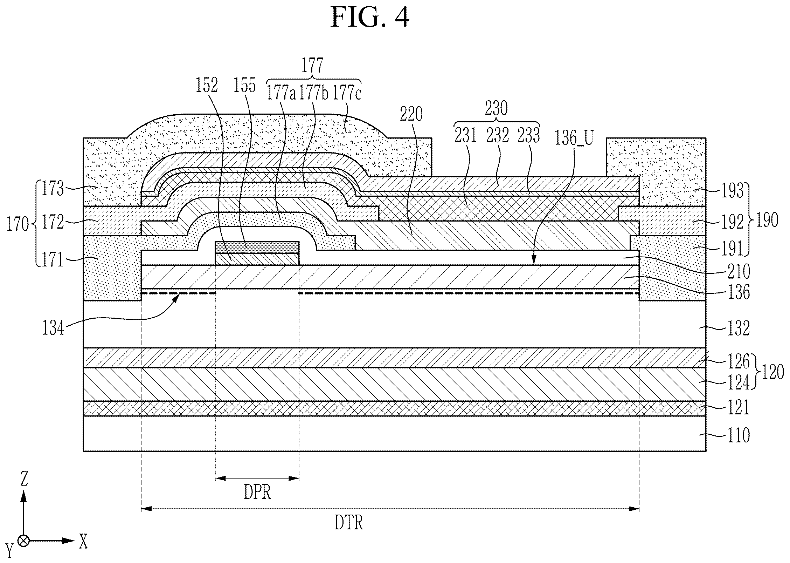

In FIGS. 1 and 2, the third protective layer 230 is illustrated as being formed of a double layer, but is not limited thereto, and the third protective layer 230 may be formed of three or more multilayers having different contents (at%) of the first material. An explanation of this will be provided later with reference to FIGS. 4 to 6e.

Hereinafter, the first to third protective layers of the semiconductor device according to an embodiment will be described with further reference to FIGS. 3a to 3d.

FIGS. 3a to 3d are graphs showing the contents of the first material of the first protective layer to the third protective layer of the semiconductor device according to an embodiment.

As described above, the first protective layer 210 is positioned on the barrier layer 136, the second protective layer 220 is positioned on the first protective layer 210, and the third protective layer 230 is positioned on the second protective layer 220. The first protective layer 210 to the third protective layer 230 may include the first material.

Referring further to FIGS. 3a to 3d, the third protective layer 230 of the semiconductor device according to an embodiment may include a portion in which the content (at%) of the first material of the third protective layer 230 is greater than the first content N1 (at%) of the first material of the first protective layer 210. In this case, the content (at%) of the first material of at least one of the third lower protective layer 231 and the third upper protective layer 232 may be greater than the first content N1 (at%) of the first material of the first protective layer 210. The maximum content (at%) of the first material of the third protective layer 230 may be greater than the maximum content (at%) of the first material of the first protective layer 210.

For example, as illustrated in FIG. 3a, the third content N3 (at%) of the first material of the third lower protective layer 231 may be greater than the first content N1 (at%) of the first material of the first protective layer 210. In such cases, the fourth content N4 (at%) of the first material of the third upper protective layer 232 may be greater than the first content N1 (at%) of the first material of the first protective layer 210, but embodiments are not limited thereto. For example, the fourth content N4 (at%) of the first material of the third upper protective layer 232 may be less than or equal to the first content N1 (at%) of the first material of the first protective layer 210. For example, the maximum content (at%) of the first material of the third protective layer 230 may be the third content N3 (at%) of the first material of the third lower protective layer 231, and the maximum content (at%) of the first material of the third protective layer 230 may be greater than the maximum content (at%) of the first material of the first protective layer 210.

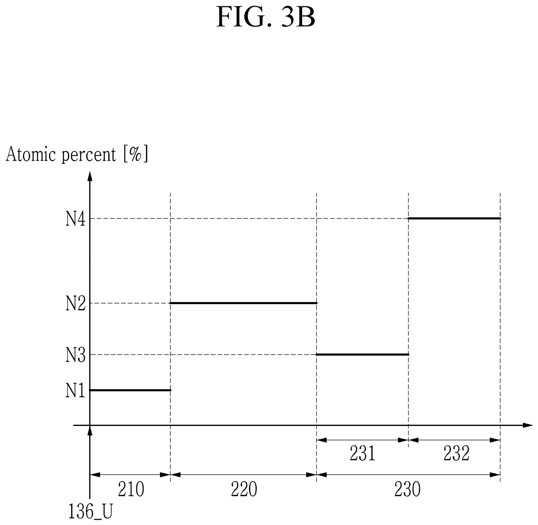

As another example, as illustrated in FIG. 3b, the fourth content N4 (at%) of the first material of the third upper protective layer 232 may be greater than the first content N1 (at%) of the first material of the first protective layer 210. In such cases, the third content N3 (at%) of the first material of the third lower protective layer 231 may be greater than the first content N1 (at%) of the first material of the first protective layer 210, but embodiments are not limited thereto. For example, the third content N3 (at%) of the first material of the third lower protective layer 231 may be less than or equal to the first content N1 (at%) of the first material of the first protective layer 210. For example, the maximum content (at%) of the first material of the third protective layer 230 may be the fourth content N4 (at%) of the first material of the third upper protective layer 232, and the maximum content (at%) of the first material of the third protective layer 230 may be greater than the maximum content (at%) of the first material of the first protective layer 210.

According to an embodiment, the third protective layer 230 of the semiconductor device may include a portion in which the content (at%) of the first material of the third protective layer 230 is greater than the second content N2 (at%) of the first material of the second protective layer 220. In this case, the content (at%) of the first material of at least one of the third lower protective layer 231 and the third upper protective layer 232 may be greater than or equal to the second content N2 (at%) of the first material of the second protective layer 220.

For example, as illustrated in FIG. 3a, the third content N3 (at%) of the first material of the third lower protective layer 231 may be greater than or equal to the second content N2 (at%) of the first material of the second protective layer 220. In such cases, the fourth content N4 (at%) of the first material of the third upper protective layer 232 may be smaller than the second content N2 (at%) of the first material of the second protective layer 220. However, embodiments are not limited thereto, and the fourth content N4 (at%) of the first material of the third upper protective layer 232 may be greater than or equal to the second content N2 (at%) of the first material of the second protective layer 220.

As another example, as illustrated in FIG. 3b, the fourth content N4 (at%) of the first material of the third upper protective layer 232 may be greater than or equal to the second content N2 (at%) of the first material of the second protective layer 220. In such cases, the third content N3 (at%) of the first material of the third lower protective layer 231 may be smaller than the second content N2 (at%) of the first material of the second protective layer 220. However, embodiments are not limited thereto, and the third content N3 (at%) of the first material of the third lower protective layer 231 may be greater than or equal to the second content N2 (at%) of the first material of the second protective layer 220.

the content (at%) of the first material in each of the first protective layer 210, the second protective layer 220, the third lower protective layer 231, and the third upper protective layer 232 may be constant as the distance increases from the upper surface 136_U of the barrier layer 136, but embodiments are not limited thereto.

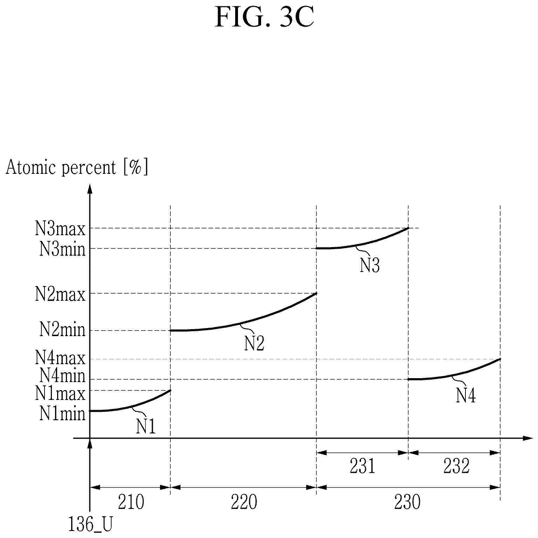

For example, as illustrated in FIG. 3c, the content (at%) of the first material of at least one of the first protective layer 210, the second protective layer 220, the third lower protective layer 231, and the third upper protective layer 232 may increase as it moves away from the upper surface 136_U of the barrier layer 136. For example, the first content N1 (at%) of the first material on the lower surface of the first protective layer 210 may have a minimum value (N1min), and the first content N1 (at%) of the first material on the upper surface of the first protective layer 210 may have a maximum value (N1max). The second content N2 (at%) of the first material on the lower surface of the second protective layer 220 may have a minimum value (N2min), and the second content N2 (at%) of the first material on the upper surface of the second protective layer 220 may have a maximum value (N2max). The third content N3 (at%) of the first material on the lower surface of the third lower protective layer 231 may have a minimum value (N3min), and the third content N3 (at%) of the first material on the upper surface of the third lower protective layer 231 may have a maximum value (N3max). The fourth content N4 (at%) of the first material on the lower surface of the third upper protective layer 232 may have a minimum value (N4min), and the fourth content N4 (at%) of the first material on the upper surface of the third upper protective layer 232 may have a maximum value (N4max). In the embodiment of FIG. 3c, the minimum value (N3min) of the third content N3 (at%) of the first material of the third lower protective layer 231 may be greater than the maximum value (N1max) of the first content N1 (at%) of the first material of the first protective layer 210. The maximum value (N3max) of the third content N3 (at%) of the first material of the third lower protective layer 231 may be greater than the maximum value (N1max) of the first content N1 (at%) of the first material of the first protective layer 210. For example, the maximum content (at%) of the first material of the third protective layer 230 may be the maximum value (N3max) of the third content N3 (at%) of the first material of the third lower protective layer 231, and the maximum content (at%) of the first material of the third protective layer 230 may be greater than the maximum content (at%) of the first material of the first protective layer 210.

In such cases, the rate at which the content (at%) of the first material of each of the first protective layer 210, the second protective layer 220, the third lower protective layer 231, and the third upper protective layer 232 increases according to the unit distance may increase as the distance increases from the upper surface 136_U of the barrier layer 136. Here, the rate of increase in the content (at%) of the first material according to the unit distance may mean the amount of change in the content according to the amount of change in the distance in the vertical direction (e.g., the thickness direction of the channel layer 132, hereinafter referred to as the 'third direction (Z direction)'). For example, the third content N3 (at%) of the first material of the third lower protective layer 231 and the fourth content N4 (at%) of the first material of the third upper protective layer 232 may increase exponentially as they move away from the upper surface 136_U of the barrier layer 136, but are not limited thereto.

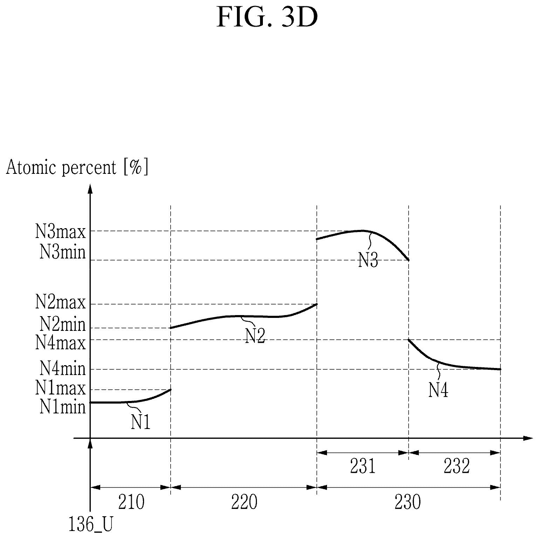

As another example, as illustrated in FIG. 3d, the content (at%) of the first material of at least one of the first protective layer 210, the second protective layer 220, the third lower protective layer 231, and the third upper protective layer 232 may include a portion that decreases as it moves away from the upper surface 136_U of the barrier layer 136. For example, the third content N3 (at%) of the first material on the upper surface of the third lower protective layer 231 may have a minimum value (N3min), and the third content N3 (at%) of the first material at the center of the third lower protective layer 231 may have a maximum value (N3max). The fourth content N4 (at%) of the first material on the upper surface of the third upper protective layer 232 may have a minimum value (N4min), and the fourth content N4 (at%) of the first material on the lower surface of the third upper protective layer 232 may have a maximum value (N4max). Even in the case of the embodiment of FIG. 3d, the minimum value (N3min) of the third content N3 (at%) of the first material of the third lower protective layer 231 may be greater than the maximum value (N1max) of the first content N1 (at%) of the first material of the first protective layer 210. The maximum value (N3max) of the third content N3 (at%) of the first material of the third lower protective layer 231 may be greater than the maximum value (N1max) of the first content N1 (at%) of the first material of the first protective layer 210.

The second content N2 (at%) of the first material of the second protective layer 220 may be greater than the first content N1 (at%) of the first material of the first protective layer 210.

According to an embodiment, the first content N1 (at%) of the first material of the first protective layer 210 of the semiconductor device may be less than the second content N2 (at%) of the first material of the second protective layer 220. In this range, the first protective layer 210 positioned on the barrier layer 136 has excellent quality, so that dangling bonds occurring at the interface between the barrier layer 136 and the first protective layer 210 may be effectively removed. Accordingly, the breakdown voltage of the semiconductor device may be increased, and the reliability of the semiconductor device may be improved by preventing the density of the two-dimensional electron gas 134 from decreasing.

Additionally, the content (at%) of the first material of at least one of the third lower protective layer 231 and the third upper protective layer 232 of the semiconductor device according to an embodiment may be greater than the first content N1 (at%) of the first material of the first protective layer 210. Additionally, the content (at%) of the first material of at least one of the third lower protective layer 231 and the third upper protective layer 232 may be greater than the second content N2 (at%) of the first material of the second protective layer 220. In this range, the hole concentration within the gate semiconductor layer 152 may be prevented from decreasing. In addition, it is possible to prevent a decrease in the density of a two-dimensional electron gas 134 formed within a channel layer 132, and to prevent deterioration of characteristics such as on-state current and on-state resistance. Therefore, semiconductor devices may have stable electrical characteristics and reliability may be improved.

Hereinafter, semiconductor devices according to some embodiments will be described with reference to FIGS. 4 to 7.

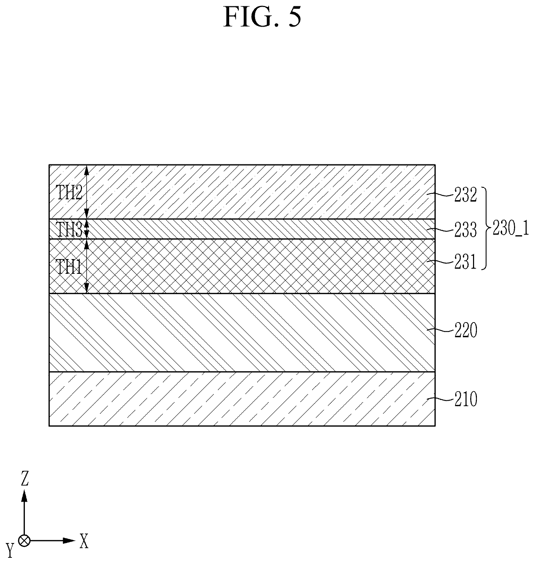

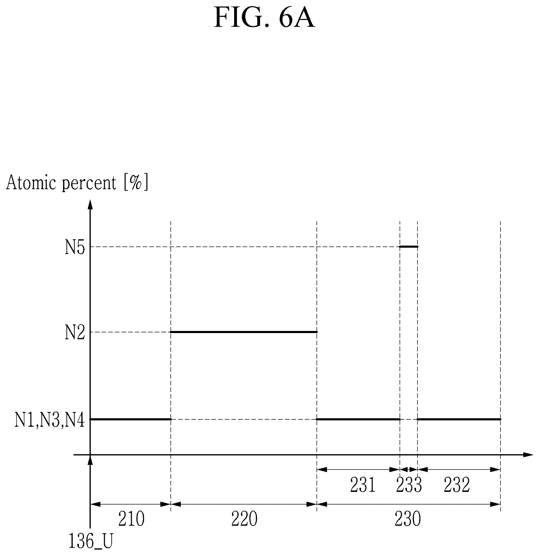

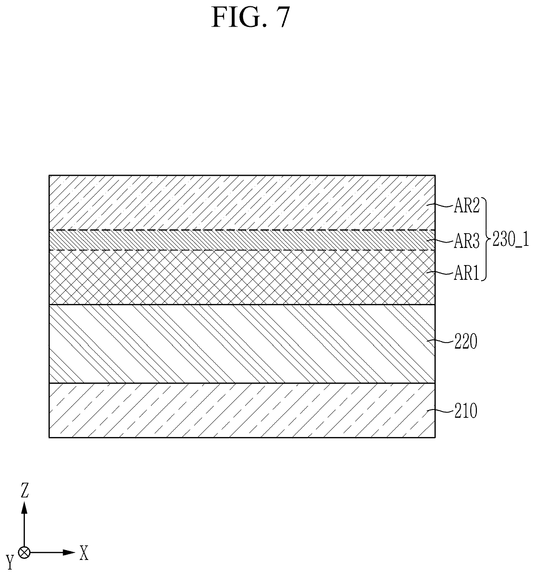

FIG. 4 is a cross-sectional view illustrating a semiconductor device according to some embodiments. FIG. 5 is a cross-sectional view showing the first to third protective layers of the embodiment of FIG. 4. FIGS. 6a to 6e are graphs showing the contents of the first material of the first to third protective layers of the semiconductor device according to the embodiment of FIG. 4. FIG. 7 is a cross-sectional view showing the first to third protective layers according to some embodiments.

FIGS. 4 to 7 illustrate various modified examples of semiconductor devices according to an embodiment illustrated in FIGS. 1 to 3d. The embodiments illustrated in FIGS. 4 to 7 are similar to the embodiments illustrated in FIGS. 1 to 3d, so a description of duplicate features thereof may be omitted and the differences will be mainly described. Additionally, the same drawing symbols are used for the same components as in the previous embodiment.

Referring to FIGS. 4 and 5, the third protective layer 230 of the semiconductor device according to some embodiments may further include a third interlayer protective layer 233 positioned between the third lower protective layer 231 and the third upper protective layer 232.

The third interlayer protective layer 233 may be positioned between the third lower protective layer 231 and the third upper protective layer 232. The third interlayer protective layer 233 may be positioned between the second field dispersion layer 177b and the third field dispersion layer 177c. The third interlayer protective layer 233 may be positioned between the third source electrode 173 and the third drain electrode 193.

In some embodiments, the third thickness TH3 of the third interlayer protective layer 233 along the third direction (Z direction) may be smaller than the first thickness TH1 of the third lower protective layer 231 along the third direction (Z direction). Additionally, the third thickness TH3 of the third interlayer protective layer 233 along the third direction (Z direction) may be smaller than the second thickness TH2 of the third upper protective layer 232 along the third direction (Z direction). For example, the third thickness TH3 of the third interlayer protective layer 233 in the third direction (Z direction) may be 1/3 to 1/64 of the thickness of the third protective layer 230 in the third direction (Z direction), but embodiments are not limited thereto.

The third interlayer protective layer 233 may be positioned at the center of the third protective layer 230. In some embodiments, the distance in the third direction (Z direction) between the lower surface of the third interlayer protective layer 233 and the lower surface of the third lower protective layer 231 may be substantially equal to, but is not limited to, the distance between the upper surface of the third interlayer protective layer 233 and the upper surface of the third upper protective layer 232. For example, the distance in the third direction (Z direction) between the lower surface of the third interlayer protective layer 233 and the lower surface of the third lower protective layer 231 may be greater than or less than the distance between the upper surface of the third interlayer protective layer 233 and the upper surface of the third upper protective layer 232.

In some embodiments, the third interlayer protective layer 233 may comprise a different material than the third lower protective layer 231 and the third upper protective layer 232. For example, the third interlayer protective layer 233 may include a nitride such as silicon nitride (SiN) or a nitride such as silicon oxynitride (SiON). As another example, the third interlayer protective layer 233 may include an oxide such as silicon oxide (SiO₂) or aluminum oxide (Al₂O₃). In an embodiment, the third interlayer protective layer 233 may include silicon nitride (SiN), silicon oxynitride (SiON), or a combination thereof, and the third lower protective layer 231 and the third upper protective layer 232 may include silicon oxide (SiO₂).

Referring further to FIG. 6a, the third interlayer protective layer 233 of the semiconductor device according to some embodiments may include the first material. In an embodiment, the third interlayer protective layer 233 may include a first material having a fifth content N5 (at%).

In some embodiments, the fifth content N5 (at%) of the first material of the third interlayer protective layer 233 may be greater than or equal to the first content N1 (at%) of the first material of the first protective layer 210 and the second content N2 (at%) of the first material of the second protective layer 220. Additionally, the fifth content N5 (at%) of the first material of the third interlayer protective layer 233 may be greater than the third content N3 (at%) of the first material of the third lower protective layer 231 and the fourth content N4 (at%) of the first material of the third upper protective layer 232. In this range, the hole concentration within the gate semiconductor layer 152 may be prevented from decreasing. In addition, it is possible to prevent a decrease in the density of a two-dimensional electron gas 134 formed within a channel layer 132, and to prevent deterioration of characteristics such as on-state current and on-state resistance. Therefore, semiconductor devices may have stable electrical characteristics and reliability may be improved.

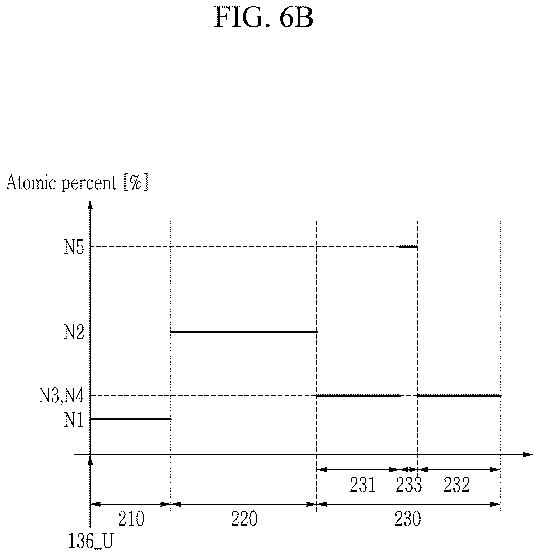

In some embodiments, the third content N3 (at%) of the first material of the third lower protective layer 231 and the fourth content N4 (at%) of the first material of the third upper protective layer 232 may be varied. For example, as illustrated in FIG. 6a, the third content N3 (at%) of the first material of the third lower protective layer 231 and the fourth content N4 (at%) of the first material of the third upper protective layer 232 may be less than the second content N2 (at%) of the first material of the second protective layer 220. The third content N3 (at%) of the first material of the third lower protective layer 231 and the fourth content N4 (at%) of the first material of the third upper protective layer 232 may be substantially the same as the first content N1 (at%) of the first material of the first protective layer 210. As another example, as illustrated in FIG. 6b, the third content N3 (at%) of the first material of the third lower protective layer 231 and the fourth content N4 (at%) of the first material of the third upper protective layer 232 may be greater than the first content N1 (at%) of the first material of the first protective layer 210.

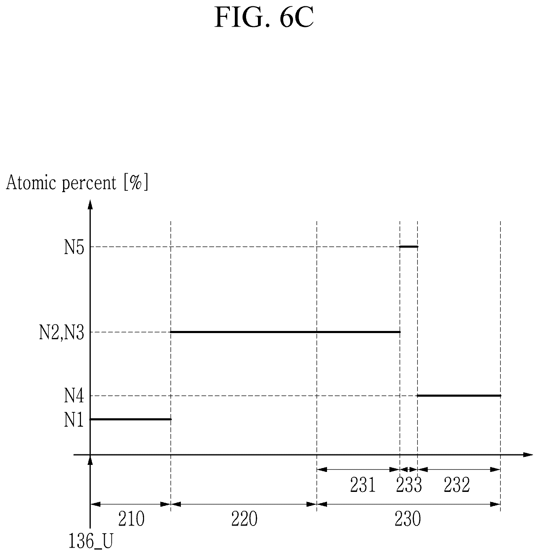

As another example, as illustrated in FIG. 6c, the third content N3 (at%) of the first material of the third lower protective layer 231 may be greater than the fourth content N4 (at%) of the first material of the third upper protective layer 232. The third content N3 (at%) of the first material of the third lower protective layer 231 may be substantially the same as the second content N2 (at%) of the first material of the second protective layer 220, and the fourth content N4 (at%) of the first material of the third upper protective layer 232 may be less than the second content N2 (at%) of the first material of the second protective layer 220.

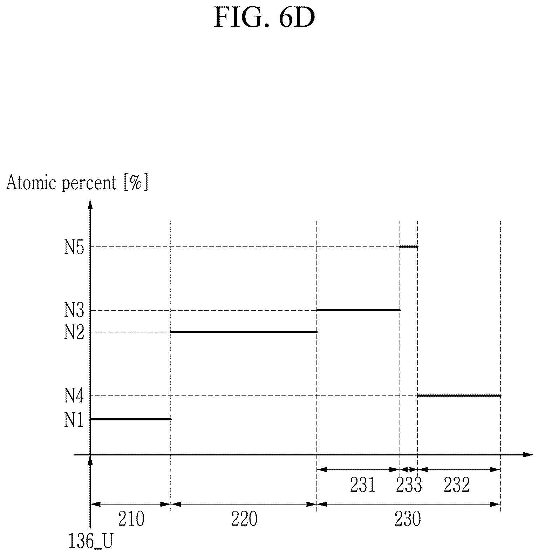

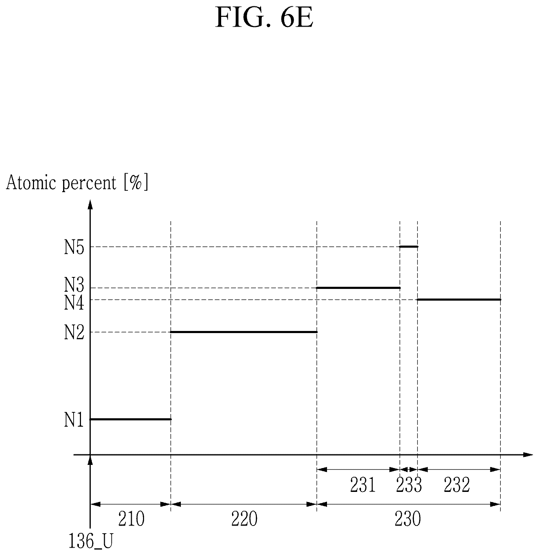

As another example, as illustrated in FIG. 6d, the third content N3 (at%) of the first material of the third lower protective layer 231 may be greater than the second content N2 (at%) of the first material of the second protective layer 220. As another example, as illustrated in FIG. 6e, the third content N3 (at%) of the first material of the third lower protective layer 231 and the fourth content N4 (at%) of the first material of the third upper protective layer 232 may be greater than the second content N2 (at%) of the first material of the second protective layer 220.

For example, the content (at%) of the first material of at least one of the third lower protective layer 231, the third interlayer protective layer 233, and the third upper protective layer 232 may be greater than or equal to the first content N1 (at%) of the first material of the first protective layer 210. Additionally, the content (at%) of the first material of at least one of the third lower protective layer 231, the third interlayer protective layer 233, and the third upper protective layer 232 may be greater than or equal to the second content N2 (at%) of the first material of the second protective layer 220.

According to some embodiments, the third lower protective layer 231, the third interlayer protective layer 233, and the third upper protective layer 232 of the semiconductor device may include various contents (at%) of the first material. In some embodiments, the fifth content N5 (at%) of the first material of the third interlayer protective layer 233 may be greater than or equal to the first content N1 (at%) of the first material of the first protective layer 210 and the second content N2 (at%) of the first material of the second protective layer 220. According to these characteristics, the density reduction of the two-dimensional electron gas 134 formed within the channel layer 132 may be further prevented, and the deterioration of characteristics such as on-state current and on-state resistance may be further prevented. Therefore, semiconductor devices may have stable electrical characteristics and reliability may be improved.

Referring to FIG. 7, a third protective layer 230_1 of a semiconductor device according to some embodiments may include a plurality of regions AR1, AR2, and AR3 including a first material and a second material different from the first material.

For example, the third protective layer 230_1 may include first region AR1 to third region AR3 sequentially positioned along the third direction (Z direction) over the second protective layer 220. The third region AR3 may be positioned between the first region AR1 and the second region AR2.

The first region AR1 to the third region AR3 may contain the same material. For example, the first region AR1 to the third region AR3 may include, but are not limited to, silicon oxide (SiO₂) or silicon nitride (SiON).

The first region AR1 to the third region AR3 may include a first material and a second material different from the first material. Here, the first material may include hydrogen(H), carbon(C), or a combination thereof, and the second material may include nitrogen(N). In some embodiments, the content (at%) of the second material in each of the first region AR1 to the third region AR3 may be different. For example, the content (at%) of the second material in the third region AR3 may be greater than the content (at%) of the second material in the first region AR1. The content (at%) of the second material in the third region AR3 may be greater than the content (at%) of the second material in the second region AR2. In some embodiments, the content (at%) of the second material in the first region AR1 may increase as it moves away from the upper surface of the second protective layer 220, but embodiments are not limited thereto. Additionally, the content (at%) of the second material in the third region AR3 may increase and then decrease as it moves away from the upper surface of the second protective layer 220, but embodiments are not limited thereto. Additionally, the content (at%) of the second material in the second region AR2 may decrease as it moves away from the upper surface of the second protective layer 220, but embodiments are not limited thereto.

Hereinafter, semiconductor devices according to some embodiments will be described with reference to FIGS. 8 to 12.

FIGS. 8 to 12 are cross-sectional views illustrating semiconductor devices according to some embodiments.

FIGS. 8 to 12 illustrate various modified examples of semiconductor devices according to an embodiment illustrated in FIGS. 1 to 3d. The embodiments illustrated in FIGS. 8 to 12 are similar to the embodiments illustrated in FIGS. 1 to 3d, so a description of features that would be duplicative thereof may be omitted and the differences will be mainly described. Additionally, the same drawing symbols are used for the same components as in the previous embodiment.

Referring to FIG. 8, a second protective layer 220 of a semiconductor device according to some embodiments may include a second lower protective layer 221 positioned over a first protective layer 210 and a second upper protective layer 222 positioned over the second lower protective layer 221.

The second lower protective layer 221 may be positioned on the first protective layer 210 and the first field dispersion layer 177a. The second lower protective layer 221 may cover the first field dispersion layer 177a. The lower surface of the second lower protective layer 221 may be in contact with the first protective layer 210 and the first field dispersion layer 177a. The second upper protective layer 222 may be positioned on the second lower protective layer 221. The second upper protective layer 222 may be positioned between the third lower protective layer 231 and the second lower protective layer 221. The upper surface of the second upper protective layer 222 may be in contact with the second field dispersion layer 177b.

The second lower protective layer 221 and the second upper protective layer 222 may include an insulating material. The second lower protective layer 221 may include the same material as the third lower protective layer 231, and the second upper protective layer 222 may include the same material as the third upper protective layer 232, but embodiments are not limited thereto. For example, the second lower protective layer 221 and the second upper protective layer 222 may include oxides such as silicon oxide (SiO₂) or aluminum oxide (Al₂O₃), but are not limited thereto. As another example, the second lower protective layer 221 and the second upper protective layer 222 may include a nitride such as silicon nitride (SiN) or a nitride such as silicon oxynitride (SiON). The second lower protective layer 221 and the second upper protective layer 222 may include the first material.

In some embodiments, the content (at%) of the first material of at least one of the second lower protective layer 221 and the second upper protective layer 222 may be greater than the first content (at%) of the first material of the first protective layer 210. For example, the content (at%) of the first material of one of the second lower protective layer 221 and the second upper protective layer 222 may be greater than the first content (at%) of the first material of the first protective layer 210, and the content (at%) of the other first material may be less than or equal to the first content (at%) of the first material of the first protective layer 210, but embodiments are not limited thereto.

In some embodiments, the content (at%) of the first material of at least one of the third lower protective layer 231 and the third upper protective layer 232 may be greater than the content (at%) of the first material of the second lower protective layer 221. Additionally, the content (at%) of the first material of at least one of the third lower protective layer 231 and the third upper protective layer 232 may be greater than the content (at%) of the first material of the second upper protective layer 222.

Referring to FIG. 9, the second protective layer 220 of the semiconductor device according to some embodiments may further include a second interlayer protective layer 223 positioned between the second lower protective layer 221 and the second upper protective layer 222.

The second interlayer protective layer 223 may be positioned between the second lower protective layer 221 and the second upper protective layer 222. The second interlayer protective layer 223 may be positioned between the first field dispersion layer 177a and the second field dispersion layer 177b. The second interlayer protective layer 223 may be positioned between the second source electrode 172 and the second drain electrode 192.

In some embodiments, the thickness of the second interlayer protective layer 223 along the third direction (Z direction) may be smaller than the thickness of the second lower protective layer 221 along the third direction (Z direction). Additionally, the thickness of the second interlayer protective layer 223 in the third direction (Z direction) may be smaller than the thickness of the second upper protective layer 222 in the third direction (Z direction). For example, the thickness of the second interlayer protective layer 223 in the third direction (Z direction) may be 1/3 to 1/64 of the thickness of the second protective layer 220 in the third direction (Z direction), but embodiments are not limited thereto.

In some embodiments, the second interlayer protective layer 223 may comprise a different material than the second lower protective layer 221 and the second upper protective layer 222. For example, the second interlayer protective layer 223 may include a nitride such as silicon nitride (SiN) or a nitride such as silicon oxynitride (SiON). As another example, the second interlayer protective layer 223 may include an oxide such as silicon oxide (SiO₂) or aluminum oxide (Al₂O₃). In an embodiment, the second interlayer protective layer 223 may include silicon nitride (SiN), silicon oxynitride (SiON), or a combination thereof, and the second lower protective layer 221 and the second upper protective layer 222 may include silicon oxide (SiO₂).

The second interlayer protective layer 223 of the semiconductor device according to some embodiments may include the first material. In some embodiments, the content (at%) of the first material of the second interlayer protective layer 223 may be greater than the first content (at%) of the first material of the first protective layer 210. Additionally, the content (at%) of the first material of the second interlayer protective layer 223 may be greater than the content (at%) of the first material of the second lower protective layer 221 and the content (at%) of the first material of the second upper protective layer 222. In some embodiments, the content (at%) of the first material of at least one of the third lower protective layer 231 and the third upper protective layer 232 may be greater than the content (at%) of the first material of the second interlayer protective layer 223.

Referring to FIG. 10, a first protective layer 210 of a semiconductor device according to some embodiments may include a first lower protective layer 211 positioned over a barrier layer 136 and a first upper protective layer 212 positioned over the first lower protective layer 211.

The first lower protective layer 211 may be positioned over the barrier layer 136 and the gate electrode 155. The first lower protective layer 211 may cover the gate electrode 155. The lower surface of the first lower protective layer 211 may be in contact with the barrier layer 136 and the gate electrode 155. The first upper protective layer 212 may be positioned on the first lower protective layer 211. The first upper protective layer 212 may be positioned between the second protective layer 220 and the first lower protective layer 211. The upper surface of the first upper protective layer 212 may be in contact with the first field dispersion layer 177a.

The first lower protective layer 211 and the first upper protective layer 212 may include an insulating material.

The first lower protective layer 211 may include the same material as the third lower protective layer 231, and the first upper protective layer 212 may include the same material as the third upper protective layer 232, but embodiments are not limited thereto. For example, the first lower protective layer 211 and the first upper protective layer 212 may include oxides such as silicon oxide (SiO₂) or aluminum oxide (Al₂O₃), but are not limited thereto. As another example, the first lower protective layer 211 may include an oxide, such as silicon oxide (SiO₂) or aluminum oxide (Al₂O₃), and the first upper protective layer 212 may include a nitride, such as silicon nitride (SiN), or a nitride, such as silicon oxynitride (SiON).

The first lower protective layer 211 and the first upper protective layer 212 may include a first material. In some embodiments, the content (at%) of the first material of the first upper protective layer 212 may be greater than the content (at%) of the first material of the first lower protective layer 211.

In some embodiments, the content (at%) of the first material of at least one of the third lower protective layer 231 and the third upper protective layer 232 may be greater than the content (at%) of the first material of the first lower protective layer 211. Additionally, the content (at%) of the first material of at least one of the third lower protective layer 231 and the third upper protective layer 232 may be greater than the content (at%) of the first material of the first upper protective layer 212.

In the embodiment of Fig. 11, the embodiments of Figs. 4 to 7 may be applied. The first protective layer 210 of the semiconductor device according to some embodiments may further include a first interlayer protective layer positioned between the first lower protective layer 211 and the first upper protective layer 212, and including a first material. The content (at%) of the first material of the first interlayer protective layer may be greater than the content (at%) of the first material of the first lower protective layer 211 and the content (at%) of the first material of the first upper protective layer 212.

Referring to FIG. 11, a semiconductor device according to some embodiments may further include a capping layer 240 positioned over the third protective layer 230 and the third field dispersion layer 177c. The capping layer 240 may cover the third field dispersion layer 177c. The lower surface of the capping layer 240 may be in contact with the third field dispersion layer 177c and the third protective layer 230. The thickness of the capping layer 240 along the third direction (Z direction) may be greater than the thickness of the third protective layer 230 along the third direction (Z direction). The thickness of the capping layer 240 along the third direction (Z direction) may be greater than the thickness of the second protective layer 220 along the third direction (Z direction). The thickness of the capping layer 240 along the third direction (Z direction) may be greater than the thickness of the first protective layer 210 along the third direction (Z direction).

The capping layer 240 may include an insulating material. The capping layer 240 may include the same material as the third lower protective layer 231 or the third upper protective layer 232, but embodiments are not limited thereto. For example, the capping layer 240 may include an oxide such as silicon oxide (SiO₂) or aluminum oxide (Al₂O₃), but embodiments are not limited thereto. As another example, the capping layer 240 may include a nitride, such as silicon nitride (SiN), or a nitride, such as silicon oxynitride (SiON).

The capping layer 240 may include the first material. In some embodiments, the content (at%) of the first material of the capping layer 240 may be greater than the content (at%) of the first material of the first protective layer 210. In some embodiments, the content (at%) of the first material of at least one of the third lower protective layer 231 and the third upper protective layer 232 may be less than or equal to the content (at%) of the first material of the capping layer 240. However, embodiments are not limited thereto, and the content (at%) of the first material of at least one of the third lower protective layer 231 and the third upper protective layer 232 may be greater than the content (at%) of the first material of the capping layer 240.

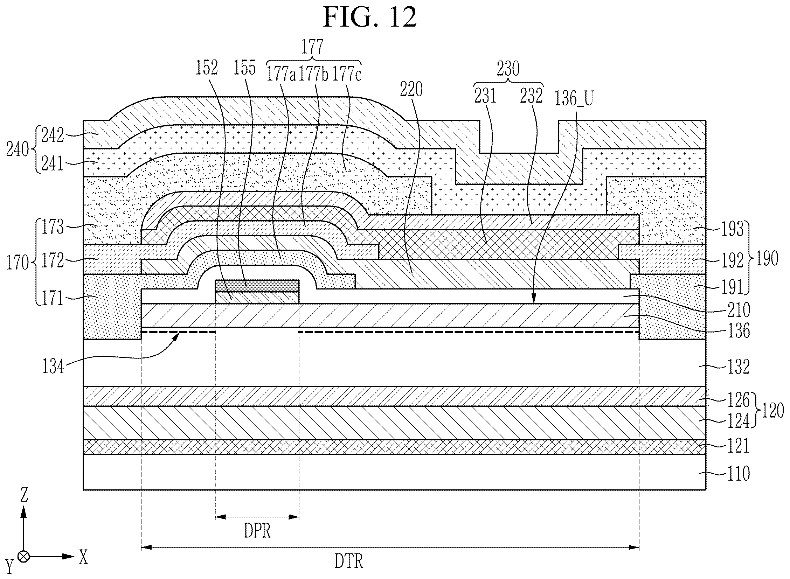

Referring to FIG. 12, a capping layer 240 of a semiconductor device according to some embodiments may include a lower capping layer 241 positioned over a third field dispersion layer 177c and a third upper protective layer 232, and an upper capping layer 242 positioned over the lower capping layer 241, and a metal wiring for improving resistance may be further formed over the upper capping layer 242. The lower capping layer 241 and the upper capping layer 242 may include various insulating materials. In some embodiments, each of the lower capping layer 241 and the upper capping layer 242 may include a first material. The content (at%) of the first material of at least one of the lower capping layer 241 and the upper capping layer 242 may be greater than the first content (at%) of the first material of the first protective layer 210.

In the embodiment of Fig. 12, the description of the embodiments of Figs. 4 to 7 are applicable to like features. The capping layer 240 of the semiconductor device according to some embodiments may further include an interlayer capping layer positioned between the lower capping layer 241 and the upper capping layer 242 and including a first material. The content (at%) of the first material of the interlayer capping layer may be greater than the content (at%) of the first material of the lower capping layer 241 and the content (at%) of the first material of the upper capping layer 242.

Hereinafter, a method for manufacturing a semiconductor device according to an embodiment will be described with reference to FIGS. 13 to 18.

FIGS. 13 to 18 are cross-sectional views showing the process sequence for manufacturing a semiconductor device according to an embodiment.

First, as illustrated in FIG. 13, a seed layer 121, a buffer layer 120, a channel layer 132, a barrier layer 136, a gate semiconductor material layer 152a, and a gate electrode material layer 155a may be sequentially formed on a substrate 110.

The substrate 110 may include a semiconductor material. For example, the substrate 110 may include sapphire, Si, SiC, AIN, GaN, or a combination thereof. The substrate 110 may be a SOI (Silicon on Insulator) substrate. However, the material of the substrate 110 is not limited to this, and all commonly used substrates may be applied.

The seed layer 121 and the superlattice layer 124 may be formed sequentially using an epitaxial growth method. The seed layer 121 and the superlattice layer 124 may be made of the same base semiconductor material. However, the material composition ratio of each layer may be different depending on the role of each layer and the performance required for the semiconductor device. The seed layer 121 and the superlattice layer 124 may include one or more materials selected from group III-V materials, for example, nitrides including Al, Ga, In, B, or combinations thereof. The seed layer 121 and the superlattice layer 124 may be AlₓIn_{y}Ga_{1-x-y}N (0≤x≤1, 0≤y≤1, x+y≤1). For example, the seed layer 121 and the superlattice layer 124 may include AIN, GaN, InN, InGaN, AlGaN, AlInN, AlInGaN, or a combination thereof.

In an embodiment, the superlattice layer 124 may be formed of multiple layers in which layers containing different materials are alternately stacked. For example, the superlattice layer 124 may have a structure in which layers made of AlGaN and layers made of AIN are repeatedly laminated. For example, AlGaN/AlN/AlGaN/AlN/Al/GaN/AlN may be sequentially stacked to form a superlattice layer 124.

The high resistance layer 126 may be made of a material with low conductivity so that the substrate 110 and the channel layer 132 may be electrically insulated. The high-resistivity layer may include one or more materials selected from group III-V materials, for example, nitrides including Al, Ga, In, B, or combinations thereof. The high-resistance layer 126 may be AlₓIn_{y}Ga_{1-x-y}N (0≤x≤1, 0≤y≤1, x+y≤1). For example, the high resistance layer 126 may include AIN, GaN, InN, InGaN, AlGaN, AlInN, AllnGaN, or a combination thereof. The high resistance layer 126 may be composed of a single layer or multiple layers.

In an embodiment, the channel layer 132 and the barrier layer 136 may be formed sequentially using an epitaxial growth method. For example, a channel layer 132 may be formed on a high-resistance layer 126, and a barrier layer 136 may be formed on the channel layer 132.

The channel layer 132 and the barrier layer 136 may be made of the same base semiconductor material. However, the material composition ratio of each layer may be different depending on the role of each layer and the performance required for the semiconductor device. The channel layer 132 and the barrier layer 136 may include one or more materials selected from group III-V materials, for example, nitrides including Al, Ga, In, B, or combinations thereof. The channel layer 132 and the barrier layer 136 may be AlₓIn_{y}Ga_{1-x-y}N (0≤x≤1, 0≤y≤1, x+y≤1). For example, the channel layer 132 and the barrier layer 136 may include AIN, GaN, InN, InGaN, AlGaN, AlInN, AllnGaN, or a combination thereof. The barrier layer 136 may include a material having a different energy band gap from the channel layer 132. The barrier layer 136 may have a higher energy band gap than the channel layer 132.

As an example, the substrate 110 may include Si, the seed layer 121 may include AIN, and the superlattice layer 124 may include AlGaN and AIN. The high resistance layer 126 may include GaN, the channel layer 132 may include GaN, and the barrier layer 136 may include AlGaN. The channel layer 132 and the barrier layer 136 may be doped with impurities or may not be doped.

The gate electrode material layer 155a may be formed using a deposition process. For example, the gate electrode material layer 155a may be formed using at least one of physical vapor deposition (PVD), thermal chemical vapor deposition (thermal CVD), low-pressure chemical vapor deposition (LP-CVD), plasma-enhanced chemical vapor deposition (PE-CVD), or atomic layer deposition (ALD) techniques, but embodiments are not limited thereto.

The gate electrode material layer 155a may include a conductive material. For example, the gate electrode material layer 155a may include a metal, a metal alloy, a conductive metal nitride, a metal silicide, a doped semiconductor material, a conductive metal oxide, or a conductive metal nitride. For example, the gate electrode material layer 155a may be titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbide nitride (TiAlC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), It may include, but is not limited to, molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof. The gate electrode material layer 155a may be formed of a single layer or multiple layers.

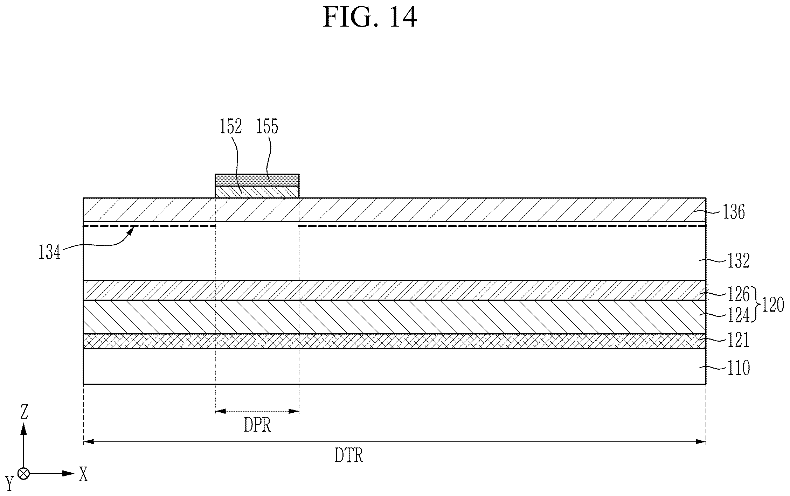

As illustrated in FIG. 14, a gate electrode 155 and a gate semiconductor layer 152 may be formed by patterning a gate electrode material layer 155a and a gate semiconductor material layer 152a using a photo and etching process.

For example, a hard mask layer and a photoresist layer may be sequentially formed on a gate electrode material layer 155a. A photoresist pattern may be formed by patterning a photoresist layer using a photo process. By etching the hard mask layer and the gate electrode material layer 155a using the photoresist pattern as a mask, the hard mask pattern and the gate electrode 155 may be formed. Next, by etching the gate semiconductor material layer 152a using the hard mask pattern as a mask, at least a portion of the gate semiconductor material layer 152a may be removed.

Accordingly, the portion of the gate electrode material layer 155a remaining may become the gate electrode 155. Additionally, the remaining portion of the gate semiconductor material layer 152a may become the gate semiconductor layer 152. The gate semiconductor layer 152 is located between the barrier layer 136 and the gate electrode 155. The gate electrode 155 may be in Schottky contact or ohmic contact with the gate semiconductor layer 152. In such cases, the hard mask layer may be removed depending on the etching conditions during etching of the gate semiconductor material layer or the cleaning conditions after etching. Alternatively, the hard mask pattern may not be removed and may remain on the gate electrode 155.

By patterning the gate semiconductor material layer 152a and the gate electrode material layer 155a using the same mask, the gate semiconductor layer 152 and the gate electrode 155 may have the same pattern. For example, the gate semiconductor layer 152 and the gate electrode 155 may have the same planar shape. In cross-section, the gate semiconductor layer 152 and the gate electrode 155 may have the same width. The gate semiconductor layer 152 may completely overlap the gate electrode 155 in the third direction (Z direction), and the upper surface of the gate semiconductor layer 152 may be entirely covered by the gate electrode 155, but embodiments are not limited thereto. For example, the gate semiconductor layer 152 and the gate electrode 155 may partially overlap in the third direction (Z direction).

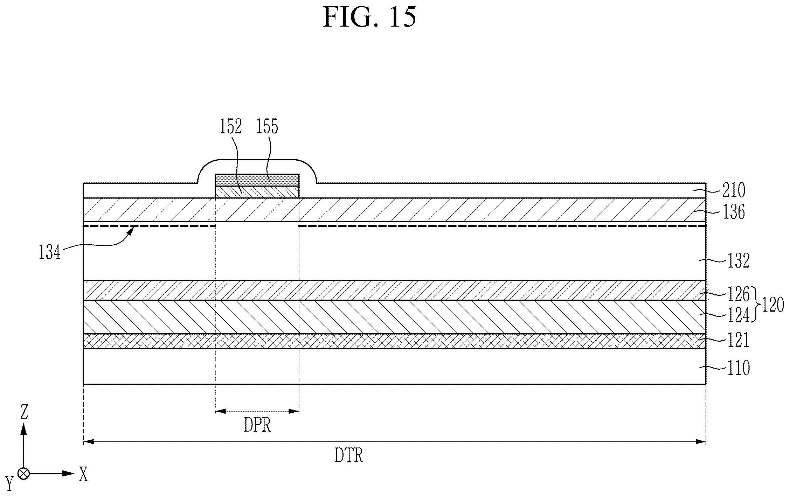

As illustrated in Fig. 15, a first protective layer 210 may be formed on the barrier layer 136 and the gate electrode 155. The first protective layer 210 may be formed using a deposition process. The first protective layer 210 may include an oxide such as silicon oxide (SiO₂) or aluminum oxide (Al₂O₃), but embodiments are not limited thereto. The first protective layer 210 may include a first material.

As illustrated in FIG. 16, the first protective layer 210 may be patterned to form a first trench 141 and a second trench 143, and a first source electrode 171 and a first drain electrode 191 may be formed within the first trench 141 and the second trench 143.

First, the first trench 141 and the second trench 143 may be formed by patterning the first protective layer 210 using a photo and etching process. In such cases, not only the first protective layer 210, but also the barrier layer 136 and the channel layer 132 may be patterned together.

For example, a photoresist pattern may be formed on the first protective layer 210, and the first protective layer 210, the barrier layer 136, and the channel layer 132 may be sequentially etched using this as a mask. In such cases, the first protective layer 210 and the barrier layer 136 may be penetrated by the first trench 141 and the second trench 143, and the upper surface of the channel layer 132 may be recessed. The channel layer 132 may not be penetrated by the first trench 141 or the second trench 143. For example, the depth at which the upper surface of the channel layer 132 is recessed may be smaller than the entire thickness of the channel layer 132. In such cases, the depth at which the upper surface of the channel layer 132 is recessed may be much smaller than the entire thickness of the channel layer 132. Additionally, the depth at which the upper surface of the channel layer 132 is recessed may be greater than the thickness of the barrier layer 136. However, embodiments are not limited thereto, and the depth at which the upper surface of the channel layer 132 is recessed may be changed in various ways.

The side surface of the first protective layer 210 and the side surface of the barrier layer 136 may be exposed to the outside by the first trench 141 and the second trench 143, and the upper surface and the side surface of the channel layer 132 may be exposed. The channel layer 132 may form the bottom surface and side walls of the first trench 141 and the second trench 143, and the barrier layer 136 may form the side walls of the first trench 141 and the second trench 143.

The first trench 141 and the second trench 143 may be spaced apart from each other. The first trench 141 and the second trench 143 may be positioned on opposite sides of the gate electrode 155. The first trench 141 may be positioned on one side of the gate electrode 155 so as to be spaced apart from the gate electrode 155. The second trench 143 may be positioned on the other side of the gate electrode 155 so as to be spaced apart from the gate electrode 155. The distance at which the first trench 141 is spaced from the gate electrode 155 may be smaller than the distance at which the second trench 143 is spaced from the gate electrode 155. The width, depth, etc. of the first trench 141 and the second trench 143 are depicted as being similar, but are not limited thereto. The shapes of the first trench 141 and the second trench 143 may be changed in various ways.

Next, a conductive material may be deposited in the first trench 141 and the second trench 143 and patterned to form a first source electrode 171 and a first drain electrode 191.

The first source electrode 171 and the first drain electrode 191 may include a conductive material. For example, the first source electrode 171 and the first drain electrode 191 may include a metal, a metal alloy, a conductive metal nitride, a metal silicide, a doped semiconductor material, a conductive metal oxide, or a conductive metal nitride. The first source electrode 171 and the first drain electrode 191 may be formed of a single layer or multiple layers. For example, a plurality of conductive layers containing different materials may be laminated and then patterned to form a first source electrode 171 and a first drain electrode 191.

The first source electrode 171 may be formed to fill the interior of the first trench 141. Additionally, the first source electrode 171 may be formed to cover at least a portion of the upper surface of the first protective layer 210. Accordingly, at least a portion of the first source electrode 171 may overlap the channel layer 132, the barrier layer 136, and the drift region DTR in the third direction (Z direction). Within the first trench 141, the first source electrode 171 may be in contact with the channel layer 132 and the barrier layer 136. The first source electrode 171 may be in contact with the side surfaces of the channel layer 132 and the barrier layer 136. The first source electrode 171 may cover the side surfaces of the channel layer 132 and the barrier layer 136. The first source electrode 171 may be electrically connected to the channel layer 132 through the first trench 141. The upper surface of the first source electrode 171 may protrude more than the upper surface of the first protective layer 210.

The first drain electrode 191 may be formed to fill the interior of the second trench 143. Additionally, the first drain electrode 191 may be formed to cover at least a portion of the upper surface of the first protective layer 210. Accordingly, at least a portion of the first drain electrode 191 may overlap the channel layer 132, the barrier layer 136, and the drift region DTR in the third direction (Z direction). Within the second trench 143, the first drain electrode 191 may be in contact with the channel layer 132 and the barrier layer 136. The first drain electrode 191 may be in contact with the side surfaces of the channel layer 132 and the barrier layer 136. The first drain electrode 191 may cover the side surfaces of the channel layer 132 and the barrier layer 136. The first drain electrode 191 may be electrically connected to the channel layer 132 through the second trench 143. The upper surface of the first drain electrode 191 may protrude more than the upper surface of the first protective layer 210.

The first source electrode 171 and the first drain electrode 191 may be in ohmic contact with the channel layer 132. The region in contact with the first source electrode 171 and the first drain electrode 191 within the channel layer 132 and the barrier layer 136 may be doped at a relatively high concentration compared to other regions. For example, a portion of the channel layer 132 or the barrier layer 136 may be doped by an ion implant process, an annealing process, or the like. However, embodiments are not limited thereto, and the doping process of a part of the channel layer 132 or the barrier layer 136 may be performed by various other processes. The doping process of a portion of the channel layer 132 or the barrier layer 136 may be performed before forming the first source electrode 171 and the first drain electrode 191. In some cases, the channel layer 132 may not be doped.

A two-dimensional electron gas 134 may be formed in the channel layer 132 adjacent to the barrier layer 136. The two-dimensional electron gas 134 may be positioned at the interface between the channel layer 132 and the barrier layer 136. The two-dimensional electron gas 134 may be positioned in the drift region DTR between the first source electrode 171 and the first drain electrode 191. A depletion region DPR may be formed within the channel layer 132 by a gate semiconductor layer 152 having a different energy band gap from the barrier layer 136. Accordingly, a semiconductor device according to an embodiment may have normally off characteristics. For example, the semiconductor device according to an embodiment may be a normally-off high electron mobility transistor (HEMT). In the gate-off state, the two-dimensional electron gas 134 may be positioned within the drift region DTR excluding the depletion region DPR of the channel layer 132. In the gate-on state, the flow of two-dimensional electron gas 134 continues within the depletion region DPR, so that the two-dimensional electron gas 134 may be positioned entirely within the drift region DTR.

In the step of forming the first source electrode 171 and the first drain electrode 191, the first field dispersion layer 177a may be formed together. The first field dispersion layer 177a may be positioned between the first source electrode 171 and the first drain electrode 191. The first field dispersion layer 177a may overlap with the gate electrode 155, but embodiments are not limited thereto. As another example, the first field dispersion layer 177a may be positioned spaced apart from the first source electrode 171 in the first direction (X direction). The first field dispersion layer 177a may be electrically connected to the first source electrode 171. The first field dispersion layer 177a may be formed integrally with the first source electrode 171. The first field dispersion layer 177a may include the same material as the first source electrode 171 and may be positioned in the same layer as the first source electrode 171. For example, at least a portion of the first field dispersion layer 177a and the first source electrode 171 may be positioned over the first protective layer 210. At least a portion of the first field dispersion layer 177a and the first source electrode 171 may be positioned directly on the upper surface of the first protective layer 210. At least a portion of the first field dispersion layer 177a and the first source electrode 171 may be positioned between the first protective layer 210 and the second protective layer 220.

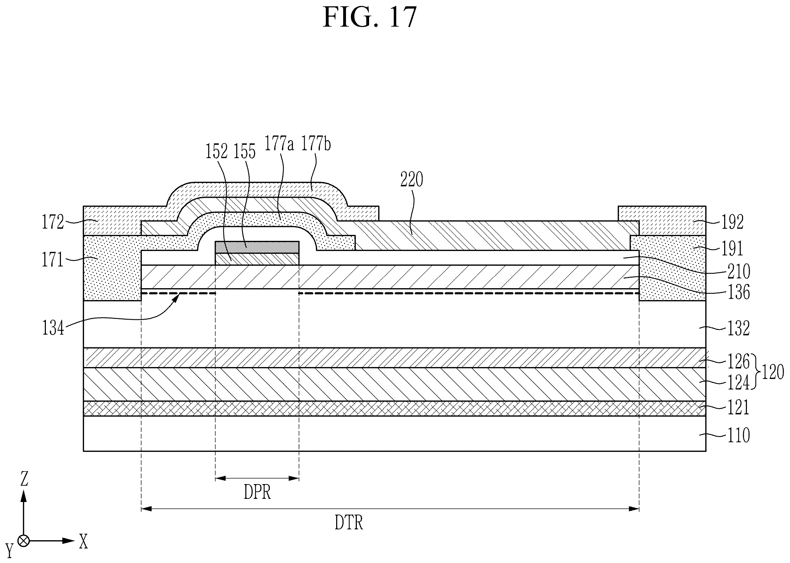

As illustrated in FIG. 17, a second protective layer 220 may be formed on the first protective layer 210 and the first field dispersion layer 177a, and a second source electrode 172 and a second drain electrode 192 may be formed penetrating the second protective layer 220.

First, a second protective layer 220 may be formed on the first protective layer 210 and the first field dispersion layer 177a. The second protective layer 220 may be formed using a deposition process. The second protective layer 220 may include an oxide such as silicon oxide (SiO₂) or aluminum oxide (Al₂O₃), but embodiments are not limited thereto. The second protective layer 220 may include the first material. In an embodiment, the second content (at%) of the first material of the second protective layer 220 may be greater than the first content (at%) of the first material of the first protective layer 210.

Next, trenches may be formed to penetrate the second protective layer 220 and expose the first source electrode 171 and the first drain electrode 191, and a second source electrode 172 and a second drain electrode 192 may be formed within the trenches. The process of forming the second source electrode 172 and the second drain electrode 192 is substantially the same as the process of forming the first source electrode 171 and the first drain electrode 191, so a description thereof may be omitted.

In the step of forming the second source electrode 172 and the second drain electrode 192, the second field dispersion layer 177b may be formed together. The second field dispersion layer 177b may be positioned between the second source electrode 172 and the second drain electrode 192. The second field dispersion layer 177b may be formed on the second protective layer 220. The second field dispersion layer 177b may be electrically connected to the second source electrode 172. The second field dispersion layer 177b may be formed integrally with the second source electrode 172, but embodiments are not limited thereto. As another example, the second field dispersion layer 177b may be positioned spaced apart from the second source electrode 172 in the first direction (X direction). The second field dispersion layer 177b may include the same material as the second source electrode 172 and may be positioned in the same layer as the second source electrode 172. For example, at least a portion of the second field dispersion layer 177b and the second source electrode 172 may be positioned over the second protective layer 220. At least a portion of the second field dispersion layer 177b and the second source electrode 172 may be positioned directly on the upper surface of the second protective layer 220. At least a portion of the second field dispersion layer 177b and the second source electrode 172 may be positioned between the second protective layer 220 and the third protective layer 230.

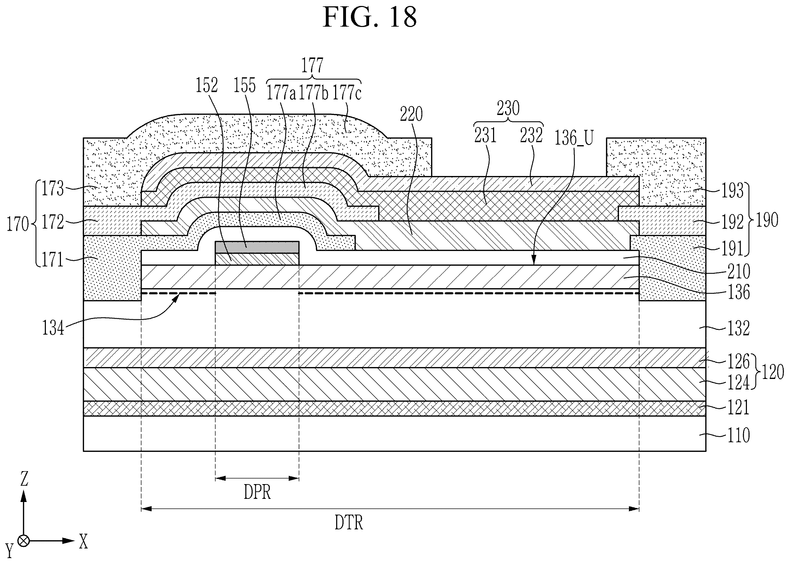

As illustrated in FIG. 18, a third lower protective layer 231 and a third upper protective layer 232 are sequentially formed on the second protective layer 220 and the second field dispersion layer 177b to form a third protective layer 230, and a third source electrode 173 and a third drain electrode 193 penetrating the third protective layer 230 may be formed.

First, a third lower protective layer 231 and a third upper protective layer 232 may be sequentially formed on the second protective layer 220 and the second field dispersion layer 177b. The third protective layer 230 may be formed using a deposition process. The third lower protective layer 231 and the third upper protective layer 232 may include oxides such as silicon oxide (SiO₂) or aluminum oxide (Al₂O₃), but are not limited thereto. The third lower protective layer 231 and the third upper protective layer 232 may include the same material or may include different materials. The third lower protective layer 231 and the third upper protective layer 232 may include the first material.

In an embodiment, the third protective layer 230 may include a portion in which the content (at%) of the first material of the third protective layer 230 is greater than the first content (at%) of the first material of the first protective layer 210. The content (at%) of the first material of at least one of the third lower protective layer 231 and the third upper protective layer 232 may be greater than the first content (at%) of the first material of the first protective layer 210. In this case, the maximum content (at%) of the first material of the third protective layer 230 may be greater than the maximum content (at%) of the first material of the first protective layer 210.

In an embodiment, the third protective layer 230 may include a portion in which the content (at%) of the first material of the third protective layer 230 is greater than the second content (at%) of the first material of the second protective layer 220. The content (at%) of the first material of at least one of the third lower protective layer 231 and the third upper protective layer 232 may be greater than the second content (at%) of the first material of the second protective layer 220. In this case, the maximum content (at%) of the first material of the third protective layer 230 may be greater than the maximum content (at%) of the first material of the second protective layer 220.

Next, trenches may be formed to penetrate the third protective layer 230 and expose the second source electrode 172 and the second drain electrode 192, and a third source electrode 173 and a third drain electrode 193 may be formed within the trenches. The process of forming the third source electrode 173 and the third drain electrode 193 is substantially the same as the process of forming the second source electrode 172 and the second drain electrode 192, so a description thereof may be omitted.

In the step of forming the third source electrode 173 and the third drain electrode 193, the third field dispersion layer 177c may be formed together. The third field dispersion layer 177c may be positioned between the third source electrode 173 and the second drain electrode 192. The third field dispersion layer 177c may be formed on the third protective layer 230. The third field dispersion layer 177c may be electrically connected to the third source electrode 173. The third field dispersion layer 177c may be formed integrally with the third source electrode 173, but embodiments are not limited thereto. As another example, the third field dispersion layer 177c may be positioned spaced apart from the third source electrode 173 in the first direction (X direction). The third field dispersion layer 177c may include the same material as the third source electrode 173 and may be positioned in the same layer as the third source electrode 173. Accordingly, a semiconductor device according to an embodiment may be formed. For example, at least a portion of the third field dispersion layer 177c and the third source electrode 173 may be positioned on the third protective layer 230. At least a portion of the third field dispersion layer 177c and the third source electrode 173 may be positioned directly on the upper surface of the third protective layer 230.

Although the embodiments have been described in detail above, the scope of the invention is not limited thereto, and various modifications and improvements made by those skilled in the art fall within the scope of the invention as defined in the following claims.

Embodiments are set out in the following clauses:
Clause 1. A semiconductor device comprising:
   a channel layer;
   a barrier layer positioned on the channel layer and including a material having a different energy band gap from an energy band gap of the channel layer;
   a gate electrode positioned on the barrier layer;
   a gate semiconductor layer positioned between the barrier layer and the gate electrode;
   a first protective layer positioned on the barrier layer and covering the gate electrode, the first protective layer comprising a first material;
   source electrodes located on a first side of the gate electrode and connected to the channel layer;
   drain electrodes located on a second side opposite the first side of the gate electrode and connected to the channel layer;
   a first field dispersion layer, a second field dispersion layer, and a third field dispersion layer connected to the source electrodes and sequentially positioned on the first protective layer;
   a second protective layer positioned between the first field dispersion layer and the second field dispersion layer; and
   a third protective layer positioned between the second field dispersion layer and the third field dispersion layer and comprising the first material,
   wherein the third protective layer comprises:
      a third lower protective layer positioned on the second field dispersion layer and the second protective layer, and
      a third upper protective layer positioned between the third lower protective layer and the third field dispersion layer,
   wherein the content by atomic percentage (at%) of the first material in at least one of the third lower protective layer and the third upper protective layer is greater than the content (at%) of the first material in the first protective layer.
Clause 2. The semiconductor device of clause 1, wherein:
   the first material is hydrogen, carbon, nitrogen, or a combination thereof.
Clause 3. The semiconductor device of clause 1 or clause 2, wherein:
   the second protective layer comprises the first material, and
   the content (at%) of the first material in at least one of the third lower protective layer and the third upper protective layer is greater than the content (at%) of the first material in the second protective layer.
Clause 4. The semiconductor device of clause 3, wherein:
   the content (at%) of the first material of the second protective layer is greater than the content (at%) of the first material of the first protective layer.

### <Description of some symbols>

110: Substrate
132: Channel layer
136: Barrier layer
152: Gate semiconductor layer
155: Gate electrode
170: Source electrode
190: Drain electrode
177: Field Dispersion Layer
210: First protective layer
220: Second protective layer
230: Third protective layer

## Claims

1. A semiconductor device comprising:
channel layer (132);
a barrier layer (136) positioned on the channel layer (132) and including a material having a different energy band gap from an energy band gap of the channel layer (132);
a gate electrode (155) positioned on the barrier layer (136);
a gate semiconductor layer (152) positioned between the barrier layer (136) and the gate electrode (155);
a first protective layer (210) positioned on the barrier layer (136) and covering the gate electrode (155), the first protective layer (210) comprising a first material;
source electrodes (170) positioned on a first side of the gate electrode (155) and connected to the channel layer (132);
drain electrodes (190) positioned on a second side of the gate electrode (155) opposite the first side of the gate electrode (155) and connected to the channel layer (132);
a first field dispersion layer (177a) positioned on the first protective layer (210) and connected to the source electrodes (170);
a second protective layer (220) positioned on the first protective layer (210) and covering the first field dispersion layer (177a); and
a third protective layer (230) comprising a third lower protective layer (231) positioned on the second protective layer (220) and comprising the first material, a third upper protective layer (232) positioned on the third lower protective layer (231) and comprising the first material, and a third interlayer protective layer (233) positioned between the third lower protective layer (231) and the third upper protective layer (232) and comprising the first material,
wherein the content by atomic percentage (at%) of the first material in at least one of the third lower protective layer (231), the third interlayer protective layer (233), and the third upper protective layer (232) is greater than the content (at%) of the first material in the first protective layer (210).

2. The semiconductor device of claim 1, wherein:
the first material is hydrogen, carbon, nitrogen, or a combination thereof.

3. The semiconductor device of claim 1 or claim 2, wherein:
the second protective layer (220) comprises the first material,
the content (at%) of the first material in at least one of the third lower protective layer (231), the third interlayer protective layer (233), and the third upper protective layer (232) is greater than or equal to the content (at%) of the first material in the second protective layer (220).

4. The semiconductor device of any preceding claim, wherein:
the second protective layer (220) comprises the first material,
the content (at%) of the first material of the second protective layer (220) is greater than the content (at%) of the first material of the first protective layer (210).

5. The semiconductor device of any preceding claim, wherein:
the content (at%) of the first material of the third interlayer protective layer (233) is greater than the content (at%) of the first material of the third lower protective layer (231) and the content (at%) of the first material of the third upper protective layer (232).

6. The semiconductor device of claim 5, wherein:
the content (at%) of the first material of the third lower protective layer (231) is greater than the content (at%) of the first material of the third upper protective layer (232).

7. The semiconductor device of any preceding claim, wherein:
the second protective layer (220) comprises the first material,
the content (at%) of the first material of the third upper protective layer (232) is less than or equal to the content (at%) of the first material of the second protective layer (220).

8. The semiconductor device of any preceding claim, wherein:
the third interlayer protective layer (233) comprises silicon nitride,
the third lower protective layer (231) and the third upper protective layer (232) include silicon oxide.

9. The semiconductor device of claim 8, wherein:
the thickness of the third interlayer protective layer (233) is less than the thickness of the third lower protective layer (231).

10. The semiconductor device of any preceding claim, further comprising:
a second field dispersion layer (177b) positioned between the second protective layer (220) and the third protective layer (230) and connected to the source electrodes (170), and
a third field dispersion layer (177c) positioned on the third protective layer (230) and connected to the source electrodes (170).

11. The semiconductor device of claim 10, wherein:
the source electrodes (170) comprise:
a first source electrode (171) positioned on the channel layer (132) and penetrating through the barrier layer (136);
a second source electrode (172) positioned on the first source electrode (171), and
a third source electrode (173) positioned on the second source electrode (172);
the drain electrodes (190) comprise:
a first drain electrode (191) positioned on the channel layer (132) and penetrating the barrier layer (136);
a second drain electrode (192) positioned on the first drain electrode (191), and
a third drain electrode (193) positioned on the second drain electrode (192),
the second field dispersion layer (177b) comprises the same material as the second source electrode (172) and is positioned in the same layer as the second source electrode (172), and
the third field dispersion layer (177c) comprises the same material as the third source electrode (173) and is positioned in the same layer as the third source electrode (173).

12. The semiconductor device of claim 10 or claim 11, further comprising:
a capping layer (240) positioned on the third protective layer (230), covering the third field dispersion layer (177c), and comprising the first material,
wherein the content (at%) of the first material in at least one of the third lower protective layer (231) and the third upper protective layer (232) is less than or equal to the content (at%) of the first material in the capping layer (240).

13. The semiconductor device of any preceding claim, wherein:
the second protective layer (220) comprises:
a second lower protective layer (221) positioned on the first protective layer (210) and comprising the first material, and
a second upper protective layer (222) positioned between the second lower protective layer (221) and the third lower protective layer (231), and comprising the first material,
the content (at%) of the first material in at least one of the third lower protective layer (231) and the third upper protective layer (232) is greater than the content (at%) of the first material in the second lower protective layer (221),
wherein the content (at%) of the first material in at least one of the third lower protective layer (231) and the third upper protective layer (232) is greater than the content (at%) of the first material in the second upper protective layer (222).

14. The semiconductor device of claim 13, wherein:
the second lower protective layer (221) comprises the same material as the third lower protective layer (231),
the second upper protective layer (222) comprises the same material as the third upper protective layer (232).

15. The semiconductor device of claim 13 or claim 14, wherein:
the content (at%) of the first material in at least one of the second lower protective layer (221) and the second upper protective layer (222) is greater than the content (at%) of the first material in the first protective layer (210).
